(19) Europäisches Patentamt
European Patent Office
Office européen des brevets

(11) **EP 2 812 919 B1**

(12) **EUROPEAN PATENT SPECIFICATION**

(45) Date of publication and mention
of the grant of the patent:
**07.07.2021 Bulletin 2021/27**

(51) Int Cl.:
*H01L 25/065* (2006.01)    *H01L 23/14* (2006.01)
*H01L 23/498* (2006.01)    *H01L 23/538* (2006.01)
*H01L 25/18* (2006.01)

(21) Application number: **12816386.2**

(22) Date of filing: **03.12.2012**

(86) International application number:
**PCT/US2012/067543**

(87) International publication number:
**WO 2013/119309 (15.08.2013 Gazette 2013/33)**

(54) **STACKED DIE ASSEMBLY WITH MULTIPLE INTERPOSERS**

GESTAPELTE CHIPANORDNUNG MIT MEHREREN INTERPOSERN

ENSEMBLE DE PUCES EMPILÉES AVEC PLUSIEURS INTERPOSEURS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.02.2012 US 201213369215
17.02.2012 US 201213399939**

(43) Date of publication of application:
**17.12.2014 Bulletin 2014/51**

(73) Proprietor: **Xilinx, Inc.
San Jose, California 95124 (US)**

(72) Inventors:
• **WU, Ephrem, C.
San Jose, California 95124 (US)**
• **BANIJAMALI, Bahareh
San Jose, California 95124 (US)**
• **CHAWARE, Raghunandan
San Jose, California 95124 (US)**

(74) Representative: **Gibbs, Richard et al
Marks & Clerk LLP
Aurora
120 Bothwell Street
Glasgow G2 7JS (GB)**

(56) References cited:
**US-A- 5 949 133        US-A1- 2002 175 421
US-A1- 2006 226 527    US-A1- 2009 244 874
US-A1- 2009 267 238    US-A1- 2011 180 317**

**Description**

FIELD OF THE INVENTION

The invention relates to integrated circuit devices ("ICs"). More particularly, the invention relates to a stacked die assembly for an IC that includes multiple interposers.

BACKGROUND

Integrated circuits have become more "dense" over time, i.e., more logic features have been implemented in an IC. More recently, Stacked-Silicon Interconnect Technology ("SSIT") allows for more than one semiconductor die to be placed in a single package. SSIT ICs may be used to address increased demand for communication bandwidth. However, even though ICs using SSIT have more than one die, such ICs still have significant bandwidth restriction due to pin constraints. Hence, it is desirable to provide an SSIT IC having less bandwidth restriction.

Document US2009/244874 A1 discloses a microelectronic package comprising a substrate; a silicon patch embedded in the substrate; a first interconnect structure at a first location of the silicon patch and a second interconnect structure at a second location of the silicon patch; and an electrically conductive line in the silicon patch connecting the first interconnect structure and the second interconnect structure to each other. In an example, a microelectronic package comprises a plurality of dies, additional silicon patches and additional dies. In an example, a width of electrically conductive line may be no greater than approximately 0.2 micrometers, while the spacing between (i.e., the pitch of) at least one pair of adjacent interconnect structures is no greater than 80 microns.

SUMMARY

The invention concerns a stacked die assembly for an IC according to claim 1.

In some exemplary assemblies, the signals routed between the first interposer and the second interposer avoid the interconnect restricted area of the first interposer and the second interposer.

The assembly can also include a third integrated circuit die coupled to the first interposer, where the first integrated circuit die provides a communication bridge between the second integrated circuit die and the third integrated circuit die.

The second interposer includes fine pitch interconnects. The fine pitch interconnects can include a plurality of die-to-die interconnects. A first portion of the plurality of die-to-die interconnects can interconnect the first integrated circuit die to the first interposer. A second portion of the plurality of die-to-die interconnects can interconnect the first integrated circuit die to the second interposer. The first portion and the second portion of the plurality of die-to-die interconnects can be disposed on opposing sides of the interconnect restricted area. A third portion of the plurality of die-to-die interconnects can interconnect the second integrated circuit die to the second interposer. A portion of the plurality of conductive lines of the second interposer can be coupled to the second portion of the plurality of die-to-die interconnects and the third portion of the plurality of die-to-die interconnects in order to interconnect the first integrated circuit die to the second integrated circuit die. The second portion of the plurality of die-to-die interconnects can be located outside the interconnect restricted area, and the portion of the plurality of conductive lines can be located outside of an offset region of the second interposer associated with the interconnect restricted area.

A first edge of the first interposer and a second edge of the second interposer are positioned substantially side-by-side for abutting one another. The first interposer includes a first offset region associated with the interconnect restricted area having a first boundary that is coterminous with the first edge. The second interposer includes a second offset region associated with the interconnect restricted area having a second boundary that is coterminous with the second edge.

The interconnect restricted area can include no metal layer and no via layer used for providing a fine pitch interconnect.

A first height of the first interposer can be substantially the same as a second height of the second interposer. In one example not forming part of the invention, a first width of the first interposer and a second width of the second interposer can both be less than or equal to a same lithographic maximum width.

The second integrated circuit die can include a vertical stack of memory dies, and interface logic for the vertical stack of memory dies.

A method for forming an assembly is also described according to independent claim 8.

Some exemplary methods also include reserving a portion of each of the first interposer and the second interposer to provide an interconnect restricted area. Routing the signals between the first interposer and the second interposer can include avoiding the interconnect restricted area of the first interposer and the second interposer.

The method can further include interconnecting a third integrated circuit die to the first interposer, where the first integrated circuit die provides a communication bridge between the second integrated circuit die and the third integrated circuit die.

The method can further include forming the first interposer using a first mask set and forming the second interposer using a second mask set. The first mask set can be substantially different from the second mask set responsive at least in part to the second integrated circuit die being for a different type of integrated circuit than the first integrated circuit die.

A first height of the first interposer can be substantially the same as a second height of the second interposer. In one example not forming part of the invention, a first width of the first interposer and a second width of the second interposer can both be less than or equal to a same lithographic maximum width.

BRIEF DESCRIPTION OF THE DRAWINGS

FIG. 1 is a simplified block diagram depicting an exemplary columnar Field Programmable Gate Array ("FPGA") architecture.

FIG. 2 is a block diagram depicting an exemplary communications line card.

FIG. 3 is a block diagram depicting an exemplary communications system.

FIG. 4 is a block diagram depicting another exemplary communications system.

FIG. 5 is a block diagram depicting an exemplary single interposer die.

FIG. 6-1 is a block diagram depicting an exemplary stacked die assembly.

FIG. 6-2 is a block diagram depicting another exemplary stacked die assembly.

FIG. 6-3 is a block diagram depicting yet another exemplary stacked die assembly.

FIG. 7-1 is a block diagram depicting an exemplary cross-sectional view of any of the stacked die assemblies of FIGS. 6-1, 6-2, or 6-3.

FIG. 7-2 is a block diagram depicting a cross-sectional view of another stacked die assembly.

FIG. 7-3 is a block diagram depicting a cross-sectional view of yet another exemplary stacked die assembly.

FIG. 8 is a block diagram depicting a top view of an interposer assembly.

FIG. 9-1 is a block diagram depicting an exemplary wafer.

FIG. 9-2 is a block diagram depicting another exemplary wafer.

FIG. 10-1 is a block diagram depicting a cross-sectional view of yet another exemplary stacked die assembly.

FIG. 10-2 is a block diagram depicting a cross-sectional view of yet another exemplary stacked die assembly.

FIG. 11 is a flow diagram depicting an exemplary process for forming one or more stacked die assemblies.

FIG. 12 is a block diagram illustrating a topographic view of a first exemplary integrated circuit (IC) structure.

FIG. 13-1 is a block diagram illustrating a cross-sectional side view of the IC structure of FIG. 12.

FIG. 13-2 is a block diagram illustrating a blow-up of a portion of the IC structure shown in FIG. 13-1.

FIG. 14 is a block diagram illustrating a topographic view of a second exemplary IC structure.

FIG. 15 is a block diagram illustrating a cross-sectional side view of the IC structure of FIG. 14.

FIG. 16 is a block diagram illustrating a further cross-sectional side view of the IC structure of FIG. 14.

FIG. 17 is a block diagram illustrating a topographic view of a third exemplary IC structure.

DETAILED DESCRIPTION

In the following description, numerous specific details are set forth to provide a more thorough description of the invention. It should be apparent, however, to one skilled in the art, that the invention may be practiced without all the specific details given below. In other instances, well known features have not been described in detail so as not to obscure the examples. For ease of illustration, the same number labels are used in different diagrams to refer to the same items; however, in alternative embodiments the items may be different.

Before describing the examples illustratively depicted in the several figures, a general introduction is provided to further understanding.

Heretofore a memory pool with DDR3 or DDR4 DRAM, or memory with serial links, was pin limited which limited bandwidth of an IC. For example, currently line-side bandwidth is approximately 200 gigabits per second ("Gbps"); however, next generation devices may have line-side bandwidth of approximately 400 Gbps. To support 400 Gbps, DDR memory may have a bandwidth on the order of approximately 1.2 terabits per second ("Tbps"). Unfortunately, there are not enough DDR memory pins on an FPGA to support 1.2 Tbps using conventional approaches. By way of example and not limitation, serial memory, such as DRAM with serial I/Os, may use 64 transceivers which involves 256 signal pins in addition to power, ground, and other reference pins to support 200 Gbps. Another limitation on bandwidth had to do with the amount of pins available for line-side and system-side serializers-deserializers ("SERDES"). As a side, system-side bandwidth is significantly larger than line-side bandwidth, and thus a system-side interface would benefit more from additional pins.

With Stacked-Silicon Interconnect Technology ("SSIT"), more than one active die may be coupled to an interposer or carrier die, whether such interposer is an active interposer or a passive interposer. For purposes of clarity and not limitation, it shall be assumed that a passive interposer is used, even though in other examples, not forming part of the invention, an active interposer may be used. Yet, heretofore, even with SSIT, interposer area was too small to provide a sufficient pin count for obtaining for example enough bandwidth for a 400 Gbps application.

However, by employing SSIT with an interposer assembly as described herein, more pin sites are available even with lithographic printing size limitations. Thus, even with large semiconductor die, it is feasible to include for example more than one gigabyte of DDR DRAM with at least one other die inside a single IC package.

With the above general understanding borne in mind, various examples of stacked die assemblies are generally described below. Because one or more of the above-described embodiments are exemplified using a particular type of IC, a detailed description of such an IC is provided below. However, it should be understood that other types of ICs may also benefit from the techniques described herein.

Programmable logic devices ("PLDs") are a well-known type of integrated circuit that can be programmed to perform specified logic functions. One type of PLD, the field programmable gate array ("FPGA"), typically includes an array of programmable tiles. These programmable tiles can include, for example, input/output blocks ("IOBs"), configurable logic blocks ("CLBs"), dedicated random access memory blocks ("BRAMs"), multipliers, digital signal processing blocks ("DSPs"), processors, clock managers, delay lock loops ("DLLs"), and so forth. As used herein, "include" and "including" mean including without limitation.

Each programmable tile typically includes both programmable interconnect and programmable logic. The programmable interconnect typically includes a large number of interconnect lines of varying lengths interconnected by programmable interconnect points ("PIPs"). The programmable logic implements the logic of a user design using programmable elements that can include, for example, function generators, registers, arithmetic logic, and so forth.

The programmable interconnect and programmable logic are typically programmed by loading a stream of configuration data into internal configuration memory cells that define how the programmable elements are configured. The configuration data can be read from memory (e.g., from an external PROM) or written into the FPGA by an external device. The collective states of the individual memory cells then determine the function of the FPGA.

Another type of PLD is the Complex Programmable Logic Device, or CPLD. A CPLD includes two or more "function blocks" connected together and to input/output ("I/O") resources by an interconnect switch matrix. Each function block of the CPLD includes a two-level AND/OR structure similar to those used in Programmable Logic Arrays ("PLAs") and Programmable Array Logic ("PAL") devices. In CPLDs, configuration data is typically stored on-chip in non-volatile memory. In some CPLDs, configuration data is stored on-chip in non-volatile memory, then downloaded to volatile memory as part of an initial configuration (programming) sequence.

For all of these programmable logic devices ("PLDs"), the functionality of the device is controlled by data bits provided to the device for that purpose. The data bits can be stored in volatile memory (e.g., static memory cells, as in FPGAs and some CPLDs), in non-volatile memory (e.g., FLASH memory, as in some CPLDs), or in any other type of memory cell.

Other PLDs are programmed by applying a processing layer, such as a metal layer, that programmably interconnects the various elements on the device. These PLDs are known as mask programmable devices. PLDs can also be implemented in other ways, e.g., using fuse or antifuse technology. The terms "PLD" and "programmable logic device" include but are not limited to these exemplary devices, as well as encompassing devices that are only partially programmable. For example, one type of PLD includes a combination of hard-coded transistor logic and a programmable switch fabric that programmably interconnects the hard-coded transistor logic.

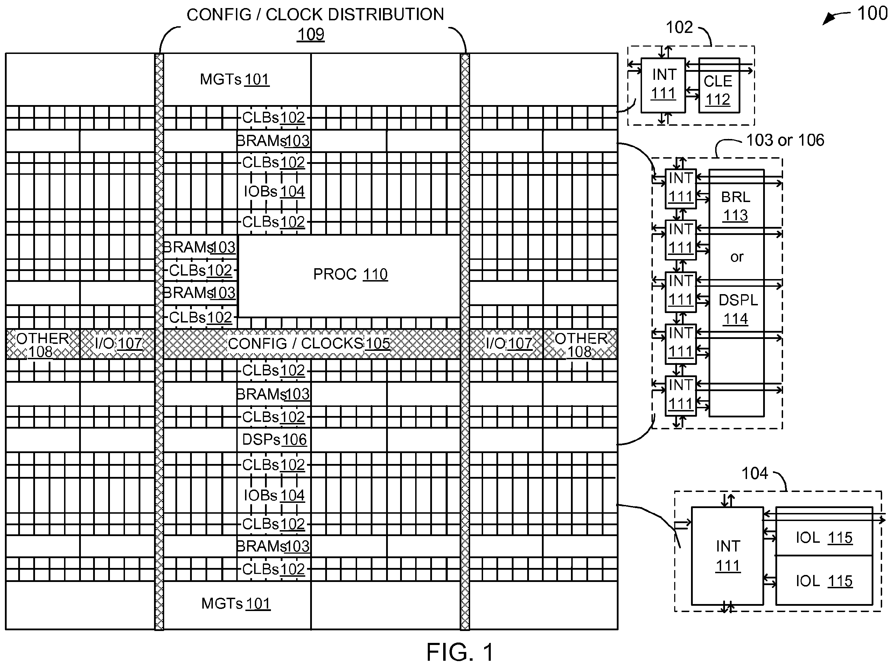

As noted above, advanced FPGAs can include several different types of programmable logic blocks in the array. For example, FIG. 1 illustrates an FPGA architecture 100 that includes a large number of different programmable tiles including multi-gigabit transceivers ("MGTs") 101, configurable logic blocks ("CLBs") 102, random access memory blocks ("BRAMs") 103, input/output blocks ("IOBs") 104, configuration and clocking logic ("CONFIG/CLOCKS") 105, digital signal processing blocks ("DSPs") 106, specialized input/output blocks ("I/O") 107 (e.g., configuration ports and clock ports), and other programmable logic 108 such as digital clock managers, analog-to-digital converters, system monitoring logic, and so forth. Some FPGAs also include dedicated processor blocks ("PROC") 110.

In some FPGAs, each programmable tile includes a programmable interconnect element ("INT") 111 having standardized connections to and from a corresponding interconnect element in each adjacent tile. Therefore, the programmable interconnect elements taken together implement the programmable interconnect structure for the illustrated FPGA. The programmable interconnect element 111 also includes the connections to and from the programmable logic element within the same tile, as shown by the examples included at the top of FIG. 1.

For example, a CLB 102 can include a configurable logic element ("CLE") 112 that can be programmed to implement user logic plus a single programmable interconnect element ("INT") 111. A BRAM 103 can include a BRAM logic element ("BRL") 113 in addition to one or more programmable interconnect elements. Typically, the number of interconnect elements included in a tile depends on the height of the tile. In the pictured example, not forming part of the invention, a BRAM tile has the same height as five CLBs, but other numbers (e.g., four) can also be used. A DSP tile 106 can include a DSP logic element ("DSPL") 114 in addition to an appropriate number of programmable interconnect elements. An IOB 104 can include, for example, two instances of an input/output logic element ("IOL") 115 in addition to one instance of the programmable interconnect element 111. As will be clear to those of skill in the art, the actual I/O pads connected, for example, to the I/O logic element 115 typically are not confined to the area of the input/output logic element 115.

In the pictured example, not forming part of the invention, a horizontal area near the center of the die (shown in FIG. 1) is used for configuration, clock, and other control logic. Vertical columns 109 extending from this horizontal area or column are used to distribute the clocks and configuration signals across the breadth of the FPGA.

Some FPGAs utilizing the architecture illustrated in FIG. 1 include additional logic blocks that disrupt the regular columnar structure making up a large part of the FPGA. The additional logic blocks can be programmable blocks and/or dedicated logic. For example, processor block 110 spans several columns of CLBs and BRAMs.

Note that FIG. 1 is intended to illustrate only an exemplary FPGA architecture. For example, the numbers of logic blocks in a row, the relative width of the rows, the number and order of rows, the types of logic blocks included in the rows, the relative sizes of the logic blocks, and the interconnect/logic implementations included at the top of FIG. 1 are purely exemplary. For example, in an actual FPGA more than one adjacent row of CLBs is typically included wherever the CLBs appear, to facilitate the efficient implementation of user logic, but the number of adjacent CLB rows varies with the overall size of the FPGA.

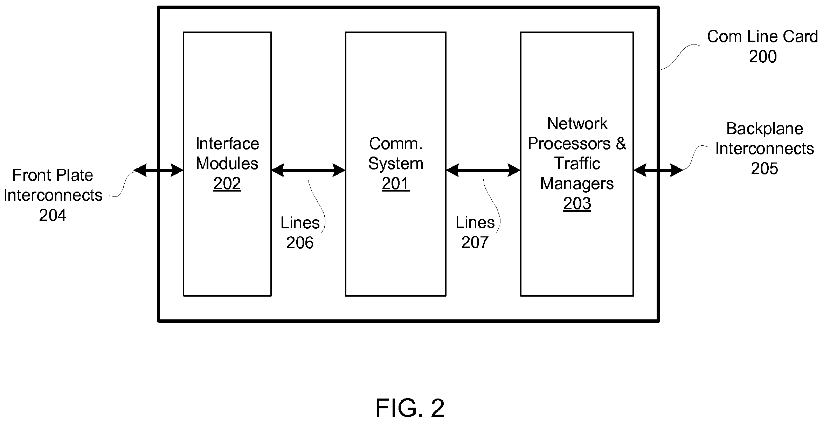

FIG. 2 is a block diagram depicting an exemplary communications line card 200, not forming part of the invention. Communications line card 200 may include one or more interface modules 202, a communications system 201, and network processors and traffic managers 203. Interface modules 202 may provide interconnects for front plate interconnects 204. Front plate interconnects 204 may be used for bidirectional communication with interface modules 202. One or more of interface modules 202 may include optical interconnects.

Interface modules 202 may be coupled to communications system 201 via lines 206. Communications system 201 may be coupled to network processors and traffic managers 203 via lines 207. Network processors and traffic managers 203 may be coupled to backplane interconnects 205. It should be understood that lines 206, lines 207, and backplane interconnects 205 may be used for bidirectional communication.

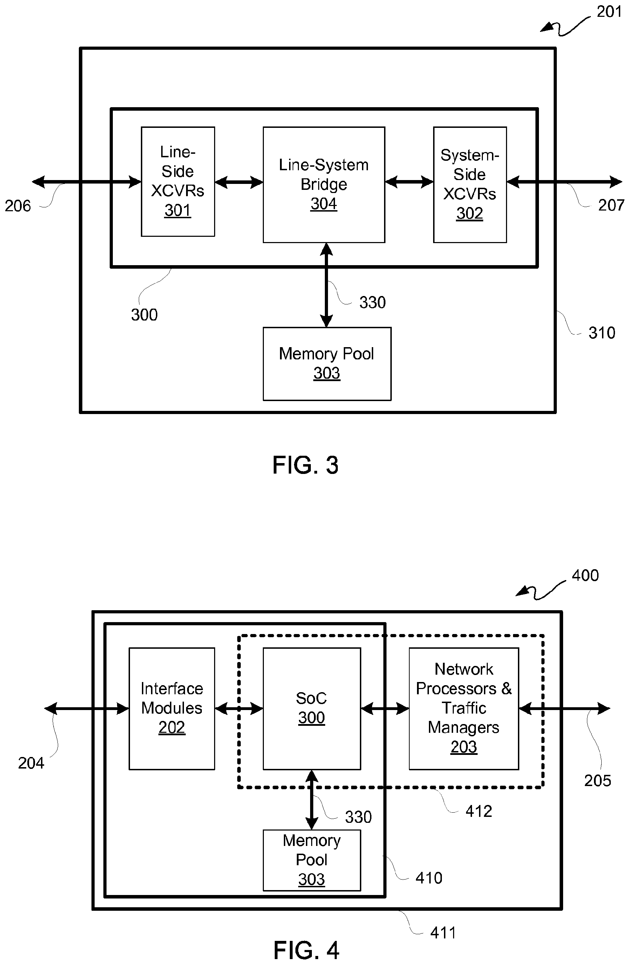

FIG. 3 is a block diagram depicting an exemplary communications system 201, not forming part of the invention. Communication system 201 may include IC dies, such as for example a System-on-a-Chip die ("SoC") 300 and one or more memory dies ("memory pool") 303. However, in other examples, not forming part of the invention, one or more of these and/or other types of IC die may be used. SoC 300 may be implemented as an FPGA, such as previously described herein for example. However, it should be understood that other types of ICs, such as ASICs, ASSP, and the like for example, may be used for providing SoC 300. In this example, SoC 300 includes line-side transceivers 301, line-system bridge 304, and system-side transceivers 302. Lines 206 may be interconnected to line-side transceivers 301, and lines 207 may be interconnected to system-side transceivers 302. Line-system bridge 304 may be interconnected to both system-side transceivers 302 and line-side transceivers 301 for bidirectional communication.

Memory pool 303 may be interconnected to line-system bridge 304 via interconnects 330 for bidirectional communication. By providing greater interconnect density as associated with interconnects 330 by use of an interposer as described herein, bandwidth of approximately 1.0 terabits per second ("Tbps") or more may be provided. For purposes of clarity by way of example and not limitation, with enough double-data-rate ("DDR") pins, bandwidth for packet buffering for a 400 or faster gigabit line card may be provided while fitting within maximum reticle dimensions using multiple interposed dies ("interposers"). Multiple interposers can be printed on a same wafer without severing at least pairs of adjacent interposers, namely an extended interposer. In another example, not forming part of the invention, interposers are completely separated from one another and subsequently coupled to one another using a bridging die. In an example, not forming part of the invention, conventional FPGA slices may be used for an extended interposer.

By fine pitch interconnects, it is generally meant interconnects with a pitch associated with lower-level metal layers. For example, some fine pitch interconnects may be 0.8 microns or less, where pitch takes into account wire width for wire spacing. In other examples, not forming part of the invention, some fine pitch interconnects may be 0.4 microns or less. It has been suggested that fine pitch interconnects can be formed with a dense metal pitch of approximately 90 nm, or 0.09 microns, in a 28 nm process. Accordingly, it should be understood that in some examples, not forming part of the invention, fine pitch interconnects may have a pitch which is less than 100 nm. In some examples, not forming part of the invention, fine pitch interconnects may be less than that supported by lithography limitations at the edge of an imaging field, namely a reduction in image quality at field edges of an image field. Examples of fine pitch interconnects include without limitation dense flip-chip micro bumps or balls with associated dense flip-chip micro bump pads. Such fine pitch interconnects may be in a staggered array, such that horizontal and vertical minimum pitches are different from one another. Accordingly, fine pitch interconnects are substantially denser than conventional flip-chip micro bumps.

An interposer assembly 310, as described herein, may be housed in a single IC package with two or more dies stacked thereon or therewith. Interposer assembly 310 may be an extended interposer having two or more interposers formed on a same wafer using same or different mask sets, where such two or more interposers are not severed from one another, namely are left joined together at what might otherwise be a scribe line area on such wafer. In another embodiment, interposer assembly 310 may be two severed dies coupled to one another by a bridging die, as described below in additional detail.

For purposes of clarity by way of example not limitation, it shall be assumed that memory pool 303 is formed with a form of double data rate ("DDR") random access memory ("RAM"), including without limitation DDR DRAM; however, it should be understood that other types of memory including other types of memory interfaces, such as QDR for example, may be used.

Generally, for communication links at 400 gigabits per second ("Gbps") and beyond, packet buffering peak bandwidth exceeds one Tbps. SSIT is capable of supporting more than one Tbps between SoC 300 and memory pool 303 using DDR-based DRAM provided a sufficient number of interconnects 330 exist between such SoC 300 and memory pool 303, which pin density is now available due to an increase of the maximum size of available interposer area, as described below.

FIG. 4 is a block diagram depicting another exemplary communications system 400. Communication system 400 may include communications system 201 of FIG. 3, interface modules 202, and network processors and traffic managers 203. Interface modules 202, SoC 300, and memory pool 303 may be interconnected to a same interposer assembly 410. Interposer assembly 410, like interposer assembly 310 of FIG. 3, may be an extended interposer in communication system 400 having two or more interposers formed on a same wafer using same or different mask sets, where such two or more interposers are not severed from one another, namely are left joined together at what might otherwise be a scribe line area on such wafer. In another example, not forming part of the invention, interposer assembly 410 may be separate interposers coupled to one another by a bridging die.

Interface modules 202, SoC 300, memory pool 303, and network processors and traffic managers 203 can be interconnected to a same interposer assembly 411, where interposer assembly 411 includes interposer assembly 410. In other words, interposer assembly 411 may include more interposers joined together than interposer assembly 410, and thus effectively interposer assembly 411 would replace or include interposer assembly 410. For SoC 300 implemented with one or more FPGAs, one or more network processor and/or one or more traffic manager of network processors and traffic managers 203 may be instantiated in such one or more FPGAs, as generally indicated with dotted line 412.

Accordingly, using an interposer assembly as described herein, a communications system 400 may be entirely contained within a single packaged IC having interposer assembly 411. In another example of communications system 400, not forming part of the invention, a single packaged IC having interposer assembly 410 may be coupled via a printed circuit board ("PCB") to network processors and traffic managers 203. By bridging interposers, whether such interposers are separate dies or an extended interposer, with an IC die, such as an SoC or other type of IC die, die-to-die interconnects, such as fine pitch interconnects for example, may be used in comparison to much larger conventional die-to-die interconnects and/or chip-to-chip interconnects, such as conventional micro bumps or micro balls, respectively, for example. Accordingly, interconnect density may be significantly enhanced by using an interposer assembly with fine pitch interconnects for die-to-die interconnecting.

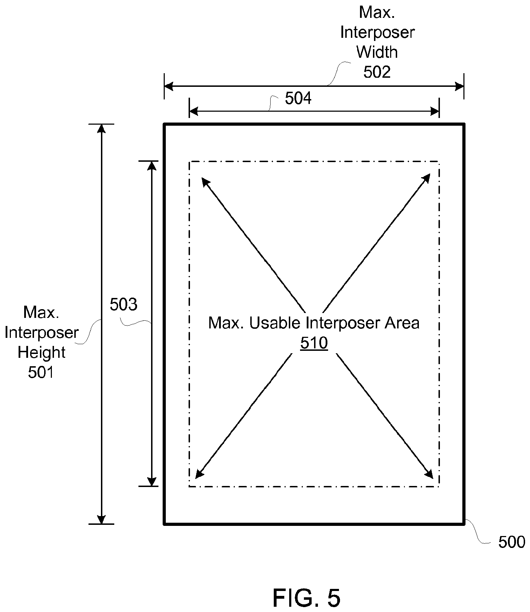

FIG. 5 is a block diagram depicting an exemplary single interposer 500. Interposer 500 has a maximum interposer height 501 and a maximum interposer width 502. These maximum height 501 and width 502 are generally determined by lithography, and in particular may be limited by reticle imaging size. Additionally restricting maximum usable interposer area 510 are offsets 511 through 514 from edges of interposer 500. These offsets may be due to providing margins for packaging and assembly, such as a package lid, scribe lines, a seal ring, and under fill margining, as well as lithographic imaging. For purposes of clarity by way of example and not limitation, interposer 500 may be cut out of a silicon wafer by first using laser ablation to create trenches along scribe lines followed by cutting with a diamond tipped circular blade along such laser ablated trenches. Laser ablation may be used to reduce chipping or delamination along such edges in comparison with cutting with a diamond tipped circular blade alone. However, laser ablation tends to leave a wider trench than cutting with a diamond tipped circular blade.

Taking into account such offsets, a maximum usable interposer height 503 and a maximum usable interposer width 504 may define a maximum usable interposer area 510. However, some of this area may be a restricted area. As described below in additional detail, for a left-side interposer of an interposer assembly, a right edge of a portion of area 510, such as offset region 512, for such left-side interposer may align with a left edge of an "interconnect restricted area." By "interconnect restricted area," it is generally meant a region associated with other regions which are not sufficiently reliable or otherwise not available for fine pitch alignment of operative fine pitch interconnects. For example, for a right-side interposer of an interposer assembly, a left edge of such right-side interposer may align with a right edge of such an interconnect restricted area. Even though right and left have been used for side-by-side interposers, a top and bottom orientation may be used.

An interconnect restricted area thus may include parts, such as offsets for example, of a first interposer and a second interposer, where signals are routed via a bridging die to avoid the interconnect restricted area of the first interposer and the second interposer. Because an offset region of an interposer may be at a far edge area of a reticle imaging field, imaging fine pitch interconnects at such far edge area may not be performed reliably. In contrast, fine pitch interconnects may be reliably formed more towards the center of such reticle imaging field, for example such as used in the formation of a die bridging first and second interposers. Thus, while fine pitch interconnects may not be reliably aligned in offset regions of first and second interposers, such fine pitch interconnects may be used to carry signals in a bridging die above such offset regions.

According to the invention, fine pitch interconnects are formed outside of an interconnect restricted area of such first and second interposers, such that a plurality of components that interconnect the integrated circuit die to the first interposer and the second interposer are located outside the interconnect restricted area. In contrast, conventional micro bumps for example may be located in an interconnect restricted area. By employing an interconnect restricted area, alignment problems associated therewith, such as for example fine pitch-to-fine pitch alignment, may be avoided by effectively positioning an inter-reticle imaging field seam, including without limitation a seam of overlapping adjacent inter-reticle imaging fields, away from inter-die interposer interconnects. Generally, an inter-reticle imaging field seam is where at least two image fields, whether from same or different reticles, of a lithographic operation overlap with one another. Thus, for example, metal wires for one inter-die interposer interface, such as for example from one group of micro bumps on one active die to another group of micro bumps on another active die, may be formed entirely within one interposer reticle field. More particularly, with respect to fine pitch interconnects, such inter-die interposer interface may be moved away from a far edge area of a reticle image field for an interposer.

An interconnect restricted area, in addition to being associated with areas of offsets, may optionally include a portion of otherwise usable area of interposer area 510, such as from a right-side and/or a left-side interposer for enhanced margin. In an extended interposer, an IC die, such as an FPGA die bridges interposers which are joined together from a same wafer, for example bridges offset regions 511 and 512 from right and left interposers, respectively, of an interposer assembly, such as interposer assembly 310 or 410 for example. Thus, scribe line areas of such interposers below such FPGA die may form at least part of an interconnect restricted area.

Additionally, in an extended interposer, because the amount of dicing cuts may be reduced, offsets may likewise be reduced as some edges of an interposer may not be cut or otherwise severed. In other words, because dicing of interposers of interposer assemblies of an extended interposer is lessened, namely some interposers are not severed from one another, scribe line area between such interposers may be reduced. However, for purposes of clarity and not limitation, it shall be assumed that scribe line areas on a wafer are generally uniform as between all dies thereof, even though in other embodiments scribe line areas on a wafer may not be generally uniform as between all dies thereof. Again, it should be understood that offset areas may be at far edge areas of a lithographic imaging field, and as such it may not be possible to reliably form fine pitch interconnects in such offset areas.

An interconnect restricted area is described at least with respect to being responsive to offset regions of interposers, and in some embodiments may include a gap between interposers and/or otherwise useable area of one or more interposers subject to lithographic imaging field geometric limitations. An interconnect restricted area may be defined as a design rule and/or layout rule for design of an interposer or interposers. In other words, such interconnect restricted area may be thought of as being on a die to which a bridging die is interconnected. Conductive lines as well as other interconnects of such interposers may likewise be associated with an interconnect restriction. Furthermore, a gap between interposers may likewise be associated with an interconnect restricted region.

Generally, for purposes of clarity and not limitation, an interconnect restricted area is referred to herein as defined on interposers responsive at least to portions of offset regions of such interposers. Moreover, for purposes of clarity and not limitation, an interconnect restriction region of an interposer is referred to herein as an offset region. Furthermore, an interconnect restricted area may be of any die, including an active die or a passive die, as an interposer may be an active device or a passive device. However, for purposes of clarity and not limitation, it shall be assumed that interposers are passive devices. Furthermore, a bridging die to connect one interposer to another interposer, whether severed or extended interposers, may be an active die or a passive die. Along those lines, it should be appreciated that fine pitch interconnects to a bridging die may be located on opposing sides of an interconnect restricted area of first and second interposers.

For purposes of clarity by way of example not limitation, maximum interposer height 501 may be approximately 31 mm (approximately 1.22 inches) after package lid footprint margining, and presently maximum interposer width 502 may be approximately 26 mm (approximately 1.024 inches) after package lid footprint margining. With scribe line and seal ring offsets, maximum usable interposer height 503 may be approximately 29 mm (approximately 1.142 inches), and maximum usable interposer width 504 may be approximately 24 mm (approximately 0.9449 inch). Thus, presently a maximum usable interposer area 510 may be approximately 700 mm$^2$ (approximately 27.56 square inches), and this maximum usable interposer area 510 should be considered in view of presently existing monolithic die sizes of approximately 600 mm$^2$ (approximately 23.62 square inches) or above for high-end devices. Heretofore, 1 gigabit of memory would have consumed approximately 25% to 50% of interposer usable area, and thus such an amount of memory could not be packaged with large high-end devices. This meant that pin counts density was significantly limited due to size of such interconnects. However, buffering using one gigabyte of memory may effectively only account for approximately 2.5 ms of 400 Gbps traffic, which may lead to an improper balance with respect to utilization of transceivers and line-system bridging.

As will be appreciated from the following description, in examples not forming part of the invention, more usable interposer area is provided by effectively bridging two or more interposers to provide a stacked die assembly. For an extended interposer, this may involve using one or more die interconnected to two or more interposers, where such interposer dies are formed on a same wafer as a single platform for providing a single IC package. In this example, the two or more interposers are physically connected to one another as a single platform, in contrast to an embodiment where two or more separated interposers make physical contact with each other. Reticle imaging fields used to form interposers may or may not overlap with one another. According to the invention, interposers are severed from one another. In yet another example, not forming part of the invention, interposer dies may be completely severed from one another and then molded together for a single IC package, as described below for example, and bridged with a bridging die.

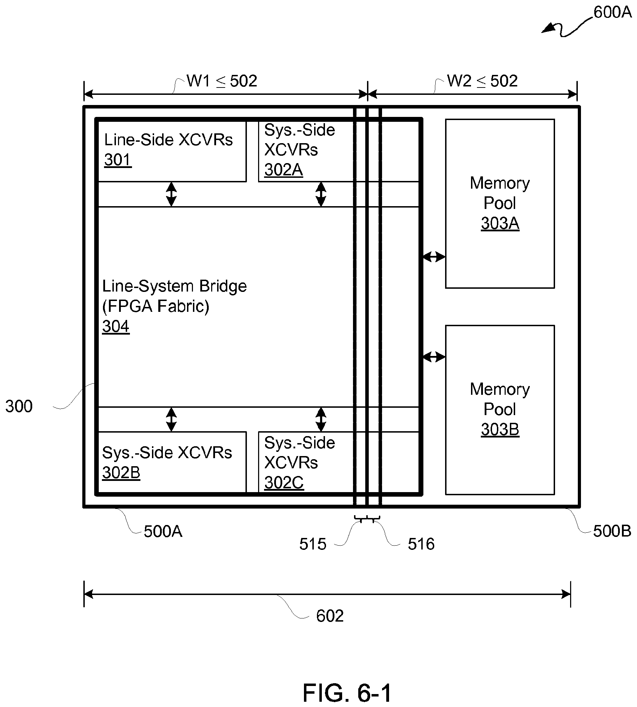

FIG. 6-1 is a block diagram depicting an assembly according to the invention such as, e.g., stacked die assembly 600A. Stacked die assembly 600A includes SoC 300, memory pools 303A and 303B, and an interposer assembly of interposers 500A and 500B whether for an extended interposer or completely severed interposers 500A and 500B. For purposes of clarity by way of example and not limitation, it shall be assumed that SoC 300 is an FPGA; however, it should be understood that other types of ICs may be used.

SoC 300 may include line-side transceivers 301, system-side transceivers 302A through 302C, and line-system bridge 304. Line-side transceivers 301 and system-side transceivers 302A through 302C may be coupled for bidirectional communication via line-system bridge 304, and such coupling may be an intra-die coupling, such as by using PIPs of an FPGA. Line-system bridge 304 may be implemented in FPGA programmable resources, namely "FPGA fabric".

SoC 300 may be interconnected to both interposer 500A and 500B, such as to a surface of interposer 500A and to a surface of interposer 500B. For example, SoC 300 may extend from an upper surface of interposer 500A to an upper surface of interposer 500B so as to bridge interposers 500A and 500B. In an extended interposer, interposers 500A and 500B are a common single platform formed of a same wafer. However, in another embodiment, interposers 500A and 500B may be separated interposers coupled to one another via SoC 300.

A portion of usable area 510 of interposer 500A bordering a left-most edge of offset region 515, as generally indicated by dotted line 710A, and/or a portion of usable area 510 of interposer 500B bordering a right-most edge of offset region 516, as generally indicated by dotted line 710B, may optionally be respective portions used to define an interconnect restricted area 599 in addition to being responsive to offset regions 515 and 516. However, for purposes of clarity and not limitation, it shall be assumed that interconnect restricted area 599 described below in additional detail is formed only responsive to offset regions 515 and 516, even though in other embodiments a portion of otherwise usable area 510 may be used.

It should be understood that SoC 300 conventionally may have dense micro bumps or other fine pitch interconnects, including conductive line interconnect components, that fall within either or both of offset regions 515 and 516. According to the invention, the interconnect restricted area 599 of interposers includes interconnects, but it does not include fine pitch interconnects. As offset regions 515 and 516 are not suitable for fine pitch interconnects, for SoC 300 to bridge interposers 500A and 500B, whether they are severed from one another or not, fine pitch "pinout" layout of such SoC 300 may not be conventional. Rather, fine pitch "pinout" layout of SoC 300 may be tailored to bridging interposers 500A and 500B. Along those lines, fine pitch interconnects of SoC 300 disposed over offset regions 515 and 516 may be aligned to coarse pitch interconnects that fall within offset regions 515 and 516, namely fall within interconnect restricted area 599, of interposers 500A and 500B.

Memory pools 303A and 303B are interconnected to a surface of interposer 500B. For example, memory pools 303A and 303B may be interconnected to an upper surface of interposer 500B for inter-die coupling with SoC 300. Memory pools 303A and 303B may be coupled to SoC 300 for bidirectional communication.

Interposers 500A and 500B may have a same or a substantially same height. Width W1 of interposer 500A may be less than or equal to a maximum interposer width 502, and width W2 of interposer 500B likewise may be less than or equal to a maximum interposer width 502. However, width W1 may be substantially larger than width W2 in order to accommodate different die sizes. An interposer assembly of interposers 500A and 500B may have an overall interposer assembly width 602 of width W1 + W2. For purposes of clarity by way of example not limitation, for an interposer height of approximately 33 mm (approximately 1.299 inches) for each of interposers 500A and 500B, an overall interposer assembly width 602 of approximately 40 millimeters (approximately 1.575 inches) may be used with SoC 300 having a width of approximately 24 millimeters (approximately 0.9449 inch). For such example, stacked die assembly 600A may fit within a single 50 mm (1.969 inches) x 50 mm (1.969 inches) package. However, in other embodiments, other heights, widths, and/or package sizes may be used.

An edge of interposer 500A and an edge of interposer 500B are positioned at least substantially side-by-side to one another. When interposers 500A and 500B are severed from one another, such edges of interposers 500A and 500B may abut one another. Interposer 500A has a reserved or offset region 515 proximal to interposer 500B. According to the invention, offset region 515 has a boundary that is coterminous with a far right edge of interposer 500A. Interposer 500B has a reserved or offset region 516 proximal to interposer 500A. According to the invention, offset region 516 has a boundary that is coterminous with a far left edge of interposer 500B.

One or both of offset regions 515 and 516 may be accounted for in dense fine pitch pinout layout of SoC 300, where SoC 300 is formed to provide an electrical interconnection within restricted area 599 associated with offset regions 515 and 516 of interposers 500A and 500B, respectively, though not with fine pitch-to-fine pitch die-to-die interconnection. Either or both of offset regions 515 and 516 may be formed such that they include no metal layer portion and no via layer portion used to provide an operative fine pitch-to-fine pitch electrical interconnection, and thus SoC 300 may not include any pinouts for corresponding fine pitch interconnects associated within such offset regions 515 and 516. Furthermore, for example, either or both of offset regions 515 and 516 may be formed such that they include no electrical interconnects and associated conductive lines.

Electrical interconnects are used to carry signal for operation of a device. Electrical interconnects may be contrasted from non-electrical interconnects for nonelectrical structures, such as for example dummy structures, such as may be used for example for lithographic imaging or otherwise.

Fine pitch die-to-die interconnects, such as die-to-die interconnects described below for example, for interconnecting SoC 300 to memory pools 303A and 303B via interposer 500B may be exclusively located on interposer 500B outside of offset region 516. All fine pitch conductive lines for interconnecting SoC 300 to memory pools 303A and 303B may be formed as part of interposer 500B outside of offset region 516.

It is possible to provide wide busses for ground planes or supply voltages, and as such fine pitch or precise interconnection is not necessarily required for such wide busses. Thus, for example, one or more fine pitch interconnects of SoC 300 may be placed for such wide busses in an interconnect restricted area of an interposer, as a fine pitch alignment restriction does not necessarily apply to such wide bussing. However, for purposes of clarity and not limitation, it shall be assumed that interconnect restricted area 599 is free of any operative interconnects, even though in other embodiments interconnects not subject to fine pitch alignment restrictions may be present in such interconnect restricted area 599.

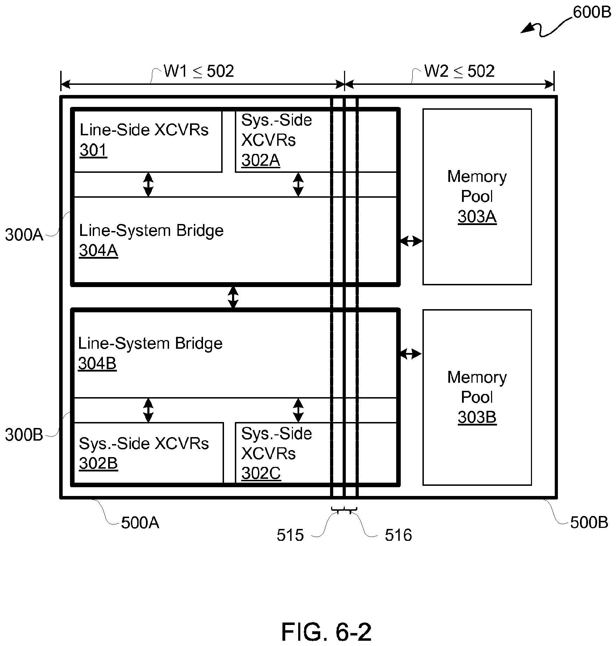

FIG. 6-2 is a block diagram depicting another exemplary stacked die assembly 600B. Stacked die assembly 600B is generally the same as stacked die assembly 600A of FIG. 6-1, except for the following differences. Rather than a single SoC 300, stacked die assembly 600B includes two SoCs, namely SoC 300A and SoC 300B. In this example, SoC 300A includes line-side transceivers 301, system-side transceivers 302A and line-system bridge 304A, and SoC 300B includes system-side transceivers 302B and 302C and line-system bridge 304B. SoCs 300A and 300B may be interconnected to one another via interconnects associated with interposer 500A.

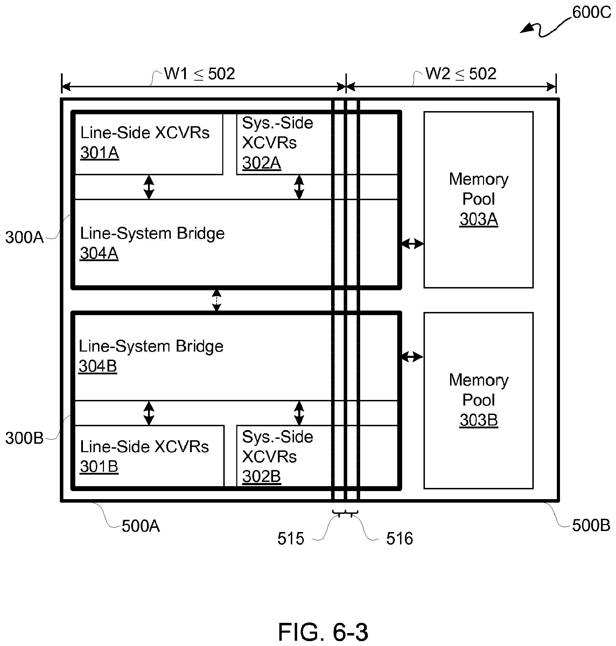

In stacked die assemblies 600A and 600B, there are more system-side transceivers than line-side transceivers. However, other configurations may be used. For example, FIG. 6-3 is a block diagram depicting yet another example of a stacked die assembly 600C. Stacked die assembly 600C is generally the same as stacked die assembly 600B of FIG. 6-2, except for the following differences. In stacked die assembly 600C, SoC 300A includes line-side transceivers 301A and system-side transceivers 302A, as well as line-system bridge 304A, and SoC 300B includes line-side transceivers 301B and system-side transceivers 302B, as well as line-system bridge 304B. Each of SoCs 300A and 300B may bridge offset regions 515 and 516 for coupling interposers 500A and 500B to one another or for interposers 500A and 500B not severed from one another. Approximately equal amounts of semiconductor area may be provided for forming line-side and system-side transceivers, and two SoCs may be used to physically bridge interposers 500A and 500B. For SoCs implemented with FPGAs, transceiver resources may be configured either for line-side or system-side.

Because interposers, such as interposers 500A and 500B, may be fabricated for particular dies, a mask set used to form interposer 500A may be substantially different from a mask set used to form interposer 500B. For example, an SoC die may be substantially different than a memory die, including without limitation substantially different sizes and pinouts.

By providing an interposer assembly as described herein, it should be understood that more transceivers, as well as more resources generally, for line-system bridging may be implemented in a single IC package along with buffer memory. Furthermore, the amount of memory may be substantially increased owing to having a larger interposer assembly footprint. Because such resources may be collectively mounted to an interposer assembly for an IC package, die-to-die interconnects may be formed with dense micro bumps for example which are significantly smaller than conventional micro bumps and substantially smaller than micro-balls. Micro-balls, which are sometimes referred to C4 solder balls, are significantly larger than conventional micro bumps and are conventionally used for an IC -to-IC interconnect via a PCB.

In other words, interconnect density is enhanced by providing an interposer assembly with a larger footprint within a package, because more area is provided for fine pitch die-to-die interconnection, which may be used instead of conventional die-to-die interconnects and/or chip-to-chip interconnects. By increasing interconnect density via an interposer assembly, bandwidth may correspondingly be increased by virtue of such interconnect density. Bandwidth increase may be further aided by an additional amount of resources available within a packaged stacked die assembly having a large interposer assembly for supporting such additional resources.

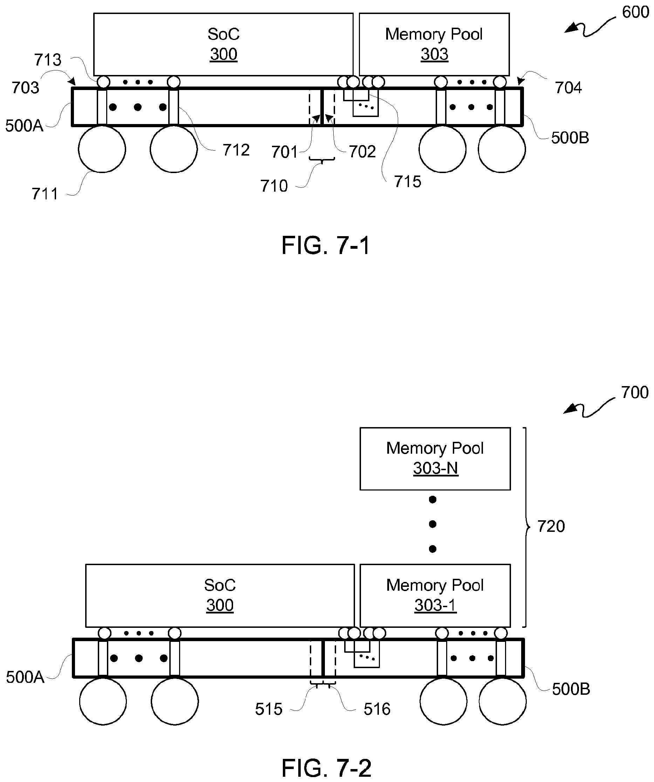

FIG. 7-1 is a block diagram depicting an exemplary cross-sectional view of any of stacked die assemblies 600A, 600B, and 600C (collectively and singly "stacked die assembly 600") of FIGS. 6-1, 6-2, or 6-3, respectively. SoC 300 and memory pool 303 are interconnected to an interposer assembly formed of interposers 500A and 500B via interconnects 713. Interconnects 713 in this example are dense die-to-die flip-chip micro bumps; however, other types of die-to-die fine pitch interconnects may be used.

SoC 300 is connected to upper surface 703 of interposer 500A via a portion of die-to-die interconnects 713, which may be fine pitch interconnects or may be conventional flip-chip micro bumps, and is connected to upper surface 704 of interposer 500B via another portion of die-to-die interconnects 713. Memory pool 303 is connected to upper surface 704 of interposer 500B via yet another portion of die-to-die interconnects 713. Some of die-to-die interconnects 713 may be coupled to other larger interconnects, which are referred to herein as "connectors" 711 so as not to be confused with die-to-die interconnects ('interconnects") 713. According to the invention, connectors 711 are coupled to interconnects 713 using "through-substrate vias", such as through-silicon vias ("TSVs") 712 for example. In this example, connectors 711 are micro-balls; however, other types of chip-to-chip large-scale interconnects may be used. Again, connectors 711 are substantially larger than interconnects 713. Accordingly, by providing an interposer assembly formed of interposers 500A and 500B, which may be joined to or severed from one another, a larger interposer area for interconnecting dies is provided so as to avoid having to use chip-to-chip interconnects. According to the invention, interposers 500A and 500B are severed from one another, namely separate dies. In other words, die-to-die interconnects are used where heretofore chip-to-chip interconnects may have been used. As interconnect density is greater with interconnects 713 than connectors 711, bandwidth may be enhanced for an IC as previously described. Furthermore, in this example, interposers 500A and 500B are silicon interposers, and thus for this example, through-substrate vias are TSVs 712; however, in other embodiments other types of substrates or die platforms may be used.

A far right edge 701 of interposer 500A according to the invention abuts a far left edge 702 of interposer 500B. Edges 701 and 702 respectively provide boundaries of offset regions 515 and 516, as previously described herein. Collectively, offset regions 515 and 516 of interposers 500A and 500B, respectively, are free of active fine pitch interconnects and associated conductive lines, namely an interconnect restricted area or region 710 which may correspond to all or portions of offset regions 515 and 516.

A portion of interconnects 713 on upper surface 704 of interposer 500B are for interconnecting SoC 300 and memory pool 303. Conductive lines, such as conductive line 715 (hereinafter singly and collectively "conductive lines 715"), which may for example be between layers of interposer 500B, are used to couple a portion of interconnects 713 located between SoC 300 and upper surface 704 with another portion of interconnects 713 located between memory pool 303 and upper surface 704. Thus, all conductive lines 715 for interconnecting SoC 300 and memory pool 303 may be provided as part of interposer 500B. In other words, all conductive lines 715 for die-to-die interconnection may be self-contained within interposer 500B. Interconnects 713 and conductive lines 715 are examples of components that may be used to interconnect SoC 300 to memory pool 303. Interconnects 713 and conductive lines 715 may singly and collectively provide fine pitch interconnects.

FIG. 7-2 is a block diagram depicting a cross-sectional view of another exemplary stacked die assembly 700. Stacked die assembly 700 is similar to stacked die assembly 600, except memory pool 303 is replaced with a vertical stack of memory dies interconnected to one another, namely stacked die memory 720. Stacked die memory 720 may include memory pool dies ("memory pools") 303-1 through 303-N, for N a positive integer greater than one. Even though not shown for purposes of clarity and not limitation, it should be understood that memory pool dies 303-1 through 303-N may be interconnected to one another, such as through use of TSVs for example, to provide stacked die memory 720. Memory pool die 303-1 may be interconnected to interposer 500B as previously described for example with reference to memory pool 303.

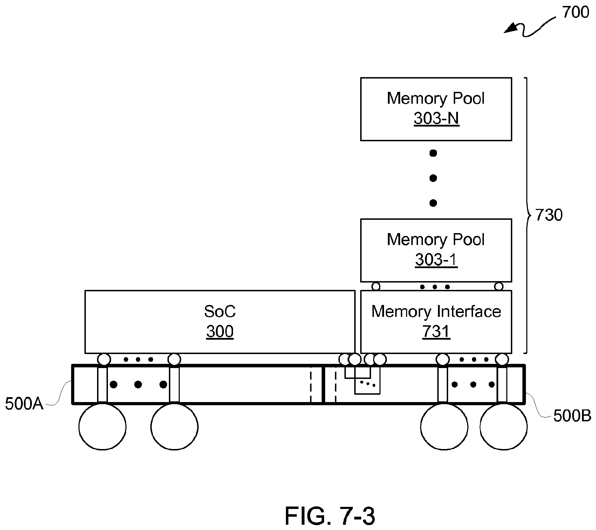

FIG. 7-3 is a block diagram depicting a cross-sectional view of yet another stacked die assembly 700. In this example, memory pool dies 303-1 through 303-N are stacked on top of a memory interface 731 for forming a stacked die memory 730. Stacked die memory 730 replaces stacked die memory 720. Memory interface 731 is interconnected to interposer 500B. Memory interface 731 may include interface logic for memory pool dies 303-1 through 303-N. Memory interface 731 is interconnected to a memory pool die 303-1 and may be interconnected to each of memory pool dies 303-1 through 303-N through one or more intervening memory pool dies thereof depending on configuration of stacked die memory 730.

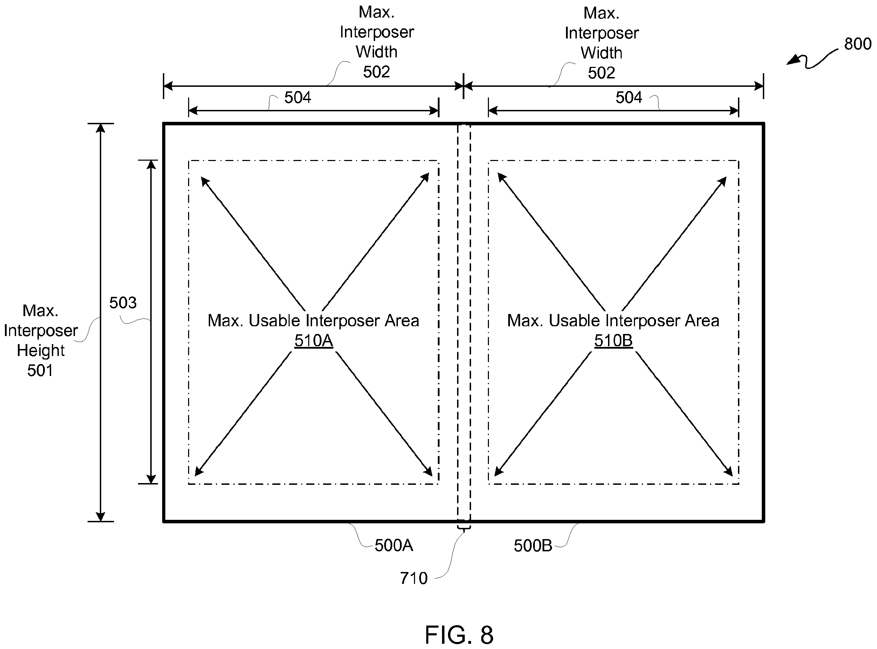

FIG. 8 is a block diagram depicting an exemplary top view of an interposer assembly 800. Interposer assembly 800 includes interposers 500A and 500B. Each of interposers 500A and 500B has a height which may be equal to or less than a maximum interposer height 501. For purposes of clarity by way of example and not limitation, both of interposers 500A and 500B in this example have a same maximum interposer height 501 and likewise have a same maximum usable height 503. However, in other embodiments, interposers 500A and 500B may have unequal heights at least one of which is not at a maximum height.

Each of interposers 500A and 500B has a width which may be equal to or less than a maximum interposer width 502. For purposes of clarity by way of example and not limitation, both of interposers 500A and 500B in this example have a same maximum interposer width 502 and likewise have a same maximum usable width 504. However, in other embodiments, interposers 500A and 500B may have unequal widths at least one of which is not a maximum width.

In this example, not forming part of the invention, electrical interconnect restricted area 710 is not defined responsive to abutting diced edges of interposers 500A and 500B, as interposers 500A and 500B in this example are formed on a same wafer or other substrate as a whole, namely are formed integral to one another as a single platform. In other words, interposers 500A and 500B are formed as a single platform in contrast to two separate platforms. Thus, interposers 500A and 500B in this example are from a same semiconductor substrate to provide a single platform. Offset regions 515 and 516 of interposers 500A and 500B may be used to define an electrical interconnect restricted area 710. However, when interposers 500A and 500B are formed as a single platform, electrical interconnect restricted area 710 need not include a scribe line seam and need not include margining for dicing for packaging. Thus, in an extended or single platform version of interposers 500A and 500B, maximum usable area may be increased over an embodiment where interposers 500A and 500B are diced to provide separate dies thereof, and accordingly, footprint of interconnect restricted area 710 may be reduced subject to interposer reticle field lithographic imaging limitations.

Because separate reticle sets are used in the formation of interposers 500A and 500B, aligning such reticle sets to one another for forming interconnects across a seam thereof may be problematic. Interconnect restricted area 710 may be enlarged to mitigate against alignment issues. Even though the example of a silicon wafer is used for the description herein of forming interposers 500A and 500B, other types of substrates may be used, including without limitation glass or another form of substrate base material.

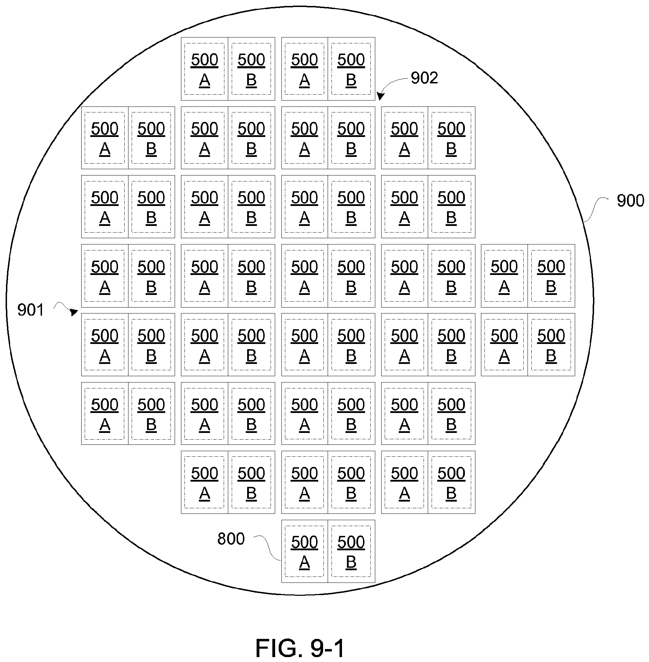

FIG. 9-1 is a block diagram depicting an exemplary wafer 900. Wafer 900 may be used for forming interposer assemblies 800 of interposers 500A and 500B. Two separate reticle sets may be used to print interposer patterns, including without limitation wires and vias, for forming interposers 500A and 500B. Wafer 900 may be laser ablated and/or sawn along horizontal rows 901 and vertical columns 902. Horizontal rows 901 and vertical columns 902 may be scribe lines. It should be appreciated that after dicing wafer 900, interposer assemblies 800, having interposers 500A and 500B formed integral to one another of the same wafer substrate material, are provided as dies of a single platform.

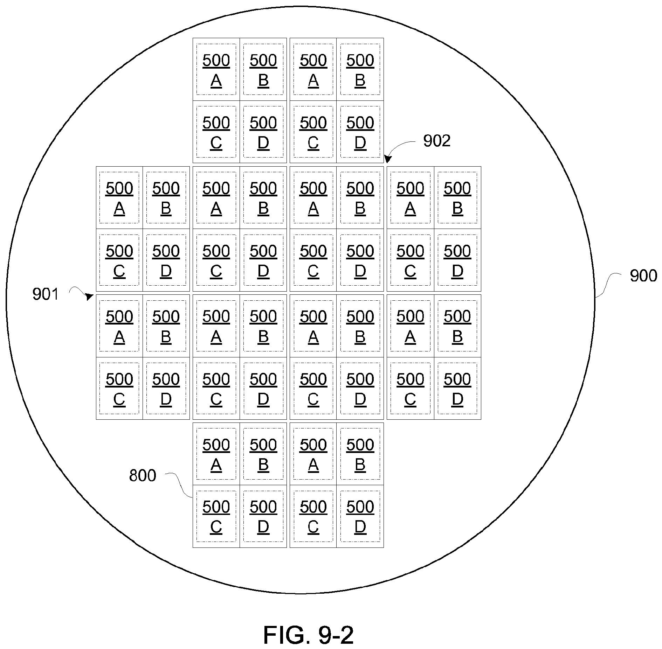

Even though two interposers are illustratively depicted for forming interposer assemblies 800, more than two interposers may be integrally formed to one another from a same wafer substrate material to be provided as dies. For example, FIG. 9-2 is a block diagram depicting an exemplary wafer 900 with interposer assemblies 800 formed of four interposers each. In this example, interposer assemblies 800 each include interposers 500A, 500B, 500C, and 500D, where such collection of interposers are formed integral to one another as single or common platform.

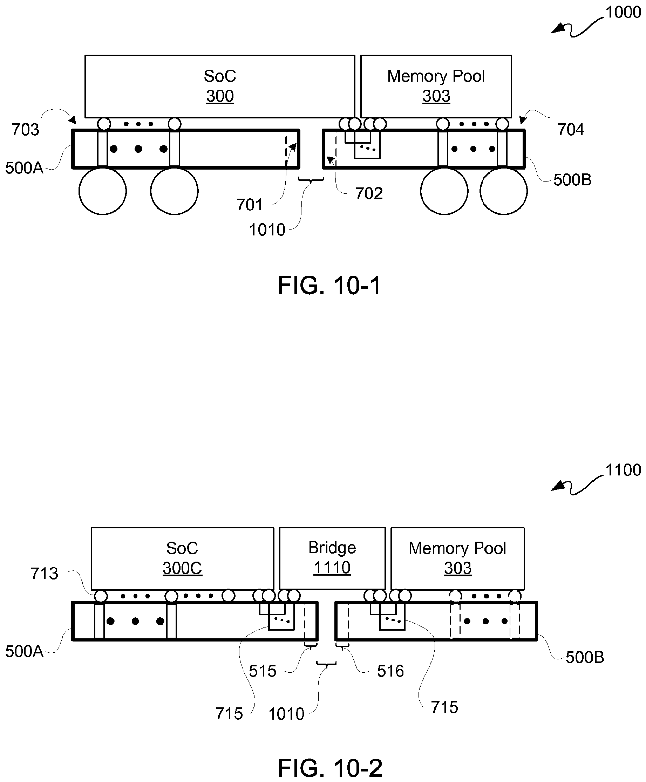

FIG. 10-1 is a block diagram depicting a cross-sectional view of an exemplary stacked die assembly 1000, not forming part of the invention. Stacked die assembly 1000 is similar to stacked die assembly 600, except that rather than abutting edges 701 and 702, a gap 1010 between such edges is provided. Edges 701 and 702 may or may not be position at lease substantially parallel to one another for such side-by-side orientation. In this example, gap 1010 effectively extends a restricted interconnect area 1049, and accordingly, as what might otherwise be pinouts under SoC 300 extending above gap 1010 may be omitted. Rather than reduce pinouts of SoC 300, a die other than SoC 300 may be used to bridge interposers 500A and 500B.

However, it should be understood that if interposers 500A and 500B have a gap 1010 between them, then a seam associated with reticle fields used to form such interposers may not exist if such interposers are formed from different wafers. However, such offset regions 515 and 516 persist, and thus for purposes of clarity and not limitation it shall be assumed that an interconnect restricted region or area 1049 persists and includes gap 1010.

FIG. 10-2 is a block diagram depicting a cross-sectional view of an exemplary stacked die assembly 1100, not forming part of the invention. Stacked die assembly 1100 is similar to stacked die assembly 1000, except for the following differences. In stacked die assembly 1100, SoC 300C does not bridge interposers 500A and 500B, and thus SoC 300C is interconnected only to interposer 500A in this example. However, a bridge die 1110 is added to interconnect an upper surface of interposer 500A and to an upper surface of interposer 500B. Bridge die 1110 spans offset regions 515 and 516, as well as gap 1010 between interposers 500A and 500B, for physically bridging such interposers. A portion of each of interposers 500A and 500B optionally may be used to provide interconnect restricted area or region 710, as previously described. For example, in an embodiment with separate interposers 500A and 500B, image quality generally along edges of image fields associated with one or more reticles used in manufacturing interposer 500A and 500B may be sufficiently degraded so as to make reliably forming fine pitch interconnects in areas or regions associated with such edges problematic. In this example, fine pitch interconnects 713 and fine pitch conductive lines 715 respectively associated with interposer 500A and 500B are all outside of offset regions 515 and 516. In such an embodiment, bridge die 1110 may be a passive device. For example, bridge die 1110 may itself be a silicon interposer. However, whether a passive or an active die, bridge die 1110 may be manufactured to have a pinout that accounts for offset regions 515 and 516, as well as gap 1010.

For purposes of clarity by way of example and not limitation, bridge die 1110 may be interconnected to SoC 300C via interposer 500A using associated fine pitch micro bumps. Moreover, bridge die 1110 may be interconnected to a memory pool die 303 via interposer 500B using associated fine pitch micro bumps.

Bridge die 1110 may optionally be an active die. Thus, for example, bridge die 1110 may provide a bidirectional communication bridge between SoC 300C and memory pool 303. By way of example and not limitation, bridge die 1110 may include buffers and/or pipelined flip-flops for die-to-die communication. For example, bridge die 1110 may provide an interconnection network between SoC 300C and memory pool 303, such as for switching for example. Bridge die 1110 may optionally include an array of bidirectional repeaters 1111 or a set of crossbar switches 1111, where each such bidirectional repeater or crossbar switch 1111 may be statically configured to be either transferring signals from a first IC to a second IC, such as for example from SoC 300C to memory pool 303, and/or the other way round. For an example, not forming part of the invention, with bidirectional repeaters 1111, configuration bits for such array of bidirectional repeaters 1111 may eventually be stored inside bridge die 1110, although such configuration bits may be initialized by one of such other ICs, such as SoC 300C or memory pool 303 for example. For an example, not forming part of the invention, with a set of at least two crossbar switches 1111, such crossbar switches 1111 may be statically configured. A P-by-Q-by-W ("PxQxW") crossbar switch 1111 has P input ports, Q output ports, and W bits per port, and may be implemented as Q instances of a P-to-1 mux with a W-bit-wide datapath. Select control lines of these P-to-1 muxes can be static so traffic between the first and the second ICs, such as between SoC 300C and memory pool 303 for example, does not have to go straight. Two crossbar switches 1111 may be used to allow traffic to be able to go from a first IC to a second IC and/or the other way round.

In this example, not forming part of the invention, offset region 515 provides a first portion of an electrical interconnect restricted area of interposer 500A outside of which fine pitch interconnects, as well as fine pitch conductive lines associated therewith, for interconnecting bridge die 1110 to interposer 500A for interconnection to SoC 300C may be formed. Likewise, offset region 516 provides a second portion of an electrical interconnect restricted area of interposer 500B outside of which fine pitch interconnects, as well as fine pitch conductive lines associated therewith, for interconnecting bridge die 1110 to interposer 500B for interconnection to memory pool 303 may be formed. Lastly, fine pitch interconnects of bridge die 1110 for bidirectional repeaters 1111 or crossbar switches 1111 may be outside of and/or extend above interconnect restricted area 1049 though are generally not available for gap 1010.

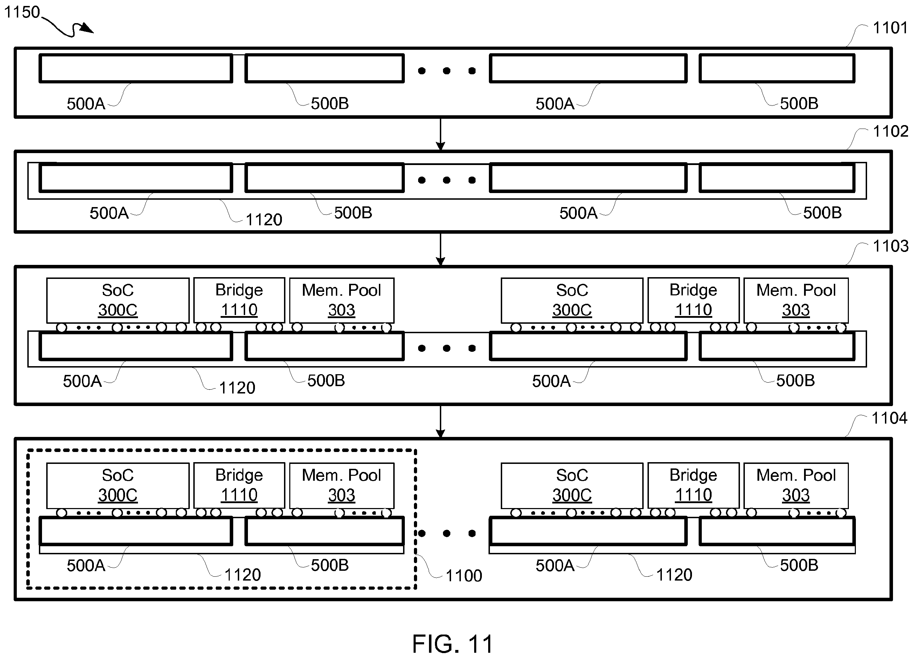

FIG. 11 is a flow diagram depicting an exemplary process 1150, not forming part of the invention, for forming one or more of stacked die assemblies 1100. Stacked die assemblies 1100 are similar to stacked die assembly 1100 of FIG. 10-2, except for the following differences. Furthermore, even though an example of stacked die assembly 1100 is used, it should be understood that stacked die assembly 1000 may be used in such process 1150.

At 1101, interposers 500A and 500B are formed as separate die for forming pairs thereof. Accordingly, interposers 500A and 500B may be diced from same or separate wafers. By way of example not limitation, one wafer may be used exclusively for forming interposers 500A, and another wafer may be used exclusively for forming interposers 500B.

At 1102, interposers 500A and 500B formed at 1101 are placed into or otherwise put in contact with a molding or packaging material 1120. Effectively at 1102, a wafer or other substrate may be re-constructed with interposers 500A and 500B in respective pairs using a mold. It should be appreciated that a portion of such packaging material 1120 extends between pairs of interposers 500A and 500B, namely extends into gap 1010.

At 1103, SoC 300C, bridge die 1110, and memory pool 303 may be interconnected to interposers 500A and 500B, as previously described herein. At 1104, stacked die assemblies 1100 may be diced from such molded substrate. Thus, unitary stacked die assemblies 1100 may be provided as set in packaging material 1120, where each such unitary stacked die assembly 1100 has a portion of packaging material 1120 extending between an edge of interposer 500A and an edge of interposer 500B.

Having two or more separate interposers with one or more bridge die may reduce stress. Furthermore, separate interposers may allow for combinations thereof to be customized by changing one or more of such interposer to accommodate different types of ICs. Total yield may be improved with a combination of separate interposers, as known good interposers may be combined to form interposer assemblies. Separate interposers may reduce warping, which may increase assembly yield during top die assembly on interposers. Separate interposers may reduce underfilling of fine pitch interconnects.

As previously mentioned, the large size of a single interposer may induce large amounts of stress on the interposer and on other IC structures that couple to the interposer. For example, solder bumps below the interposer that couple the interposer to the substrate of an IC package can be exposed to a significant amount of stress that is dependent upon the size of the interposer. Accordingly, the interposer can be split or subdivided into two or more individual interposers rather than using a single, monolithic interposer. In consequence, the smaller interposers and any IC structure coupled to the smaller interposers are subjected to reduced stress, thereby increasing reliability of the multi-die IC structure.

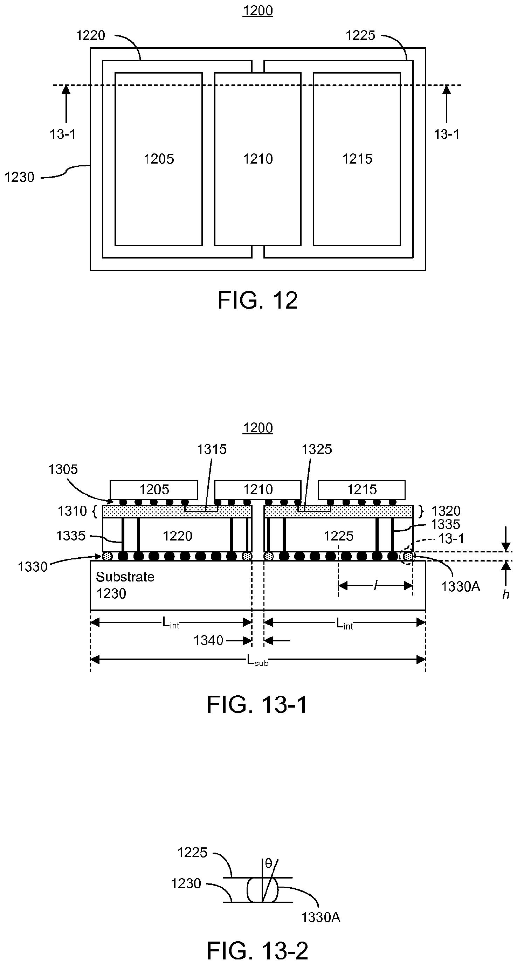

FIG. 12 is a block diagram illustrating a topographic view of an IC structure 1200, not forming part of the invention. IC structure 1200 is a multi-die IC structure. FIG. 12 illustrates a packing approach to stacking multiple dies of IC structure 1200 within a single package. As pictured in FIG. 12, IC structure 1200 can include a plurality of dies 1205, 1210, and 1215. Dies 1205-1215 can be mounted on two or more interposers 1220 and 1225. Interposers 1220 and 1225 each can be implemented as a silicon interposer. Interposers 1220 and 1225 can be mounted on a substrate 1230 of an IC package within which IC structure 1200 can be implemented.

Each of interposers 1220 and 1225 can be a die having a planar surface on which dies 1205-1215 can be horizontally stacked. As shown, dies 1205 and 1210 can be located on the planar surfaces of interposers 1220 and 1225 side-by-side. In the example shown in FIG. 12, die 1205 is mounted only to interposer 1220. Die 1215 is mounted only to interposer 1225. Die 1210 is mounted to both interposer 1220 and to interposer 1225. In general, each of dies 1205-1215 can be coplanar. Similarly, each of interposers 1220 and 1225 can be coplanar. As used within this specification, the term "coplanar" means that the enumerated structures are located in a same plane or that each enumerated structure has at least one surface that is in a same plane as the others.

Each of interposers 1220 and 1225 can provide a common mounting surface and electrical coupling point for one or more dies of a multi-die IC structure. Interposers 1220 and 1225 can serve as an intermediate layer for interconnect routing between dies 1205-1215 or as a ground or power plane for IC structure 1200. Each of interposers 1220 and 1225 can be implemented with a silicon wafer substrate, whether doped or un-doped with an N-type and/or a P-type impurity. The manufacturing of interposers 1220 and 1225 can include one or more additional process steps that allow the deposition of one or more layer(s) of metal interconnect. These metal interconnect layers can include aluminum, gold, copper, nickel, various silicides, and/or the like.

Interposers 1220 and 1225 can be manufactured using one or more additional process steps that allow the deposition of one or more dielectric or insulating layer(s) such as, for example, silicon dioxide. In general, interposer 1220 and/or 1225 can be implemented as passive dies in that one or both of interposers 1220 and/or 1225 can include no active circuit elements, e.g., no P-material in contact with N-material or "PN" junctions. In another aspect, interposers 1220 and 1225 can be manufactured using one or more additional process steps that allow the creation of active circuit elements such as, for example, transistor devices and/or diode devices. As noted, each of interposers 1220 and 1225 is, in general, a die and is characterized by the presence of one or more TSVs as will be described in greater detail within this specification.

FIG. 13-1 is a block diagram illustrating a cross-sectional side view of IC structure 1200 of FIG. 12, not forming part of the invention. More particularly, FIG. 13-1 illustrates a view of IC structure 1200 of FIG. 12 taken along cut-line 13-1-13-1. As such, like numbers will be used to refer to the same items throughout this specification.

As shown, a first (bottom) surface of interposer 1220 can be coupled to a top surface of substrate 1230. Similarly, a first (bottom) surface of interposer 1225 can be coupled to the top surface of substrate 1230. A second (top) surface of interposer 1220 can be coupled to a bottom surface of die 1205 and to a portion of a bottom surface of die 1210. A second (top) surface of interposer 1225 can be coupled to a portion of the bottom surface of die 1210 and to a bottom surface of die 1215.

In one aspect, dies 1205-1215 can be electrically coupled to interposers 1220 and 1225 via solder bumps 1305. Solder bumps 1305 can be implemented in the form of "micro-bumps," for example. More particularly, die 1205 is coupled to interposer 1220 through solder bumps 1305. Die 1210 is coupled to interposer 1220 and to interposer 1225 through solder bumps 1305. Die 1215 is coupled to interposer 1225 through solder bumps 1305. Each of solder bumps 1305 also can serve to physically attach dies 1205-1215 to interposer 1220 and/or to interposer 1225 as the case may be.

Interposer 1220 can include one or more patterned layers formed of metal or another conductive material forming interconnect region 1310. The patterned layers can be used to form inter-die wires such as inter-die wire 1315 that can pass inter-die signals between dies 1205 and 1210. For example, inter-die wire 1315 can be formed using one or more of the patterned metal layers in combination with one or more vias from interconnect region 1310. Inter-die wire 1315 can connect to one of solder bumps 1305 located between die 1205 and interposer 1220 and to another one of solder bumps 1305 located between die 1210 and interposer 1220, thereby coupling die 1205 to die 1210 and allowing the exchange of signals between dies 1205 and 1210.

Interposer 1225 can include one or more patterned layers formed of metal or another conductive material forming interconnect region 1320. Interconnect region 1320 can be substantially similar to interconnect region 1310 of interposer 1220. Accordingly, the patterned layers and vias can be used to form inter-die wires such as inter-die wire 1325. Inter-die wire 1325 can connect to one of solder bumps 1305 located between die 1210 and interposer 1225 and to another one of solder bumps 1305 located between die 1215 and interposer 1225, thereby coupling die 1210 to die 1215 and allowing the exchange of signals between dies 1210 and 1215.

Although the coupling of dies 1205-1215 to interposers 1220 and 1225 is accomplished using solder bumps 1305, a variety of other techniques can be used to couple dies 1205-1215 to interposers 1220 and 1225. For example, bond wires or edge wires can be used to couple a die to one or more interposers. In another example, an adhesive material can be used to physically attach a die to one or more interposers. As such, the coupling of dies 1205-1215 to interposers 1220 and 1225 via solder bumps 1305, as illustrated within FIG. 13-1, is provided for purposes of illustration and is not intended to limit the examples disclosed within this specification.

Solder bumps 1330 can be used to electrically couple the bottom surface of each of interposers 1220 and 1225 to substrate 1230. In an aspect, solder bumps 1330 can be implemented in the form of "C4-bumps." As noted, substrate 1230 can be part of a multi-die IC package in which IC structure 1200 is implemented. Solder bumps 1330 can be used to couple IC structure 1200 to a node external to the multi-die IC package.

Each of interposers 1220 and 1225 can include one or more through-silicon vias (TSVs) 1335. In general, each TSV 1335 can be implemented as a via formed of conductive material to form an electrical connection that vertically transverses, e.g., extends through a substantial portion, if not the entirety of, interposer 1220 and/or interposer 1225. For example, TSVs 1335 can be implemented by drilling or etching an opening into interposer 1220 and/or interposer 1225 that extends from a top planar surface, i.e., the surface to which solder bumps 1305 are coupled, through to a bottom planar surface, i.e., the surface to which solder bumps 1330 are coupled. Conductive material then can be deposited within the openings. Examples of conductive material that can be used to fill the openings to form TSVs 1335 can include, but are not limited to, aluminum, gold, copper, nickel, various silicides, and/or the like.

In the example shown in FIG. 13-1, each TSV 1335 is shown to couple to solder bumps 1305 through one or more of the patterned layers in combination with one or more vias within interconnect region 1310 in interposer 1220 or within interconnect region 1320 in interposer 1225. In another example, however, TSVs 1335 can extend substantially through interposer 1220 and interposer 1225 to couple solder bumps 1305 with solder bumps 1330 by passing through interconnect region 1310 or interconnect region 1320 as the case may be.

TSVs 1335, in combination with solder bumps 1305 and solder bumps 1330, couple die 1205 to substrate 1230 via interposer 1220. Die 1210 is coupled to substrate 1230 using TSVs 1335, solder bumps 1305, and solder bumps 1330 through interposer 1220 and through interposer 1225. Die 1215 is coupled to substrate 1230 using TSVs 1335, solder bumps 1305, and solder bumps 1330, through interposer 1225.

In one aspect, signals can be propagated from die 1205 to die 1215 through inter-die wires such as inter-die wire 1315 and inter-die wire 1325 in combination with wires or other signal paths implemented within die 1210 that couple inter-die wire 1315 with inter-die wire 1325. The signal paths implemented within die 1210 can be implemented in the form of hardwired circuitry or programmable circuitry.

For example, dies 1205-1215 can be implemented as any of a variety of different types of dies. One or more of dies 1205-1215 can be implemented as a memory device, a processor, e.g., a central processing unit, an application-specific IC, or a programmable IC. Each such type of IC can include hardwired circuitry coupling inter-die wire 1315 with inter-die wire 1325. Each of dies 1205-1215 can be implemented as a similar or same type of IC. In the alternative, die 1205 can be implemented as first type of IC, while dies 1210 and 1215 are implemented as a second and different type of IC. In still another example, each of dies 1205-1215 can be implemented as a different type of IC.

The signal paths in die 1210 that couple inter-die wire 1315 to inter-die wire 1325 can be hardwired or programmable circuitry. In the case of programmable circuitry, die 1205 can be rendered unable to communicate with die 1215 unless or until programmable circuitry is configured to implement such a connection.

Within IC structure 1200, interposer 1220 and interposer 1225 can be separated by a distance 1340. The respective edge of each of interposers 1220 and 1225 effectively forms a channel having a width equal to distance 1340 that extends between each of interposers 1220 and 1225. As shown, die 1210 effectively spans the channel between interposer 1220 and interposer 1225. Each of interposers 1220 and 1225 can have a length of $L_{int}$. Substrate 1230 can have a length of $L_{sub}$. Though illustrated as having a same length, each of interposers 1220 and 1225 can have different lengths depending upon the implementation of IC structure 100.

IC structure 1200 is subjected to a variety of different stresses. For example, interposers 1220 and 1225 are subjected to stress as each provides a structural base upon which dies are mounted. Further solder bumps and, in particular, solder bumps 1330, can be subjected to increased levels of stress. In one aspect, solder bumps 1330 that are located along one or more or all edges edge of interposer 1220 and/or 1225 can be subjected to increased levels of shear strain.

Referring to FIG. 13-1, the particular ones of solder bumps 1330 that are subjected to increased levels of shear strain are illustrated with shading as opposed to the solid coloration of the other ones of solder bumps 1330. The left-most and right-most solder bumps 1330 beneath interposer 1220 are subjected to a higher level of shear strain than other ones of the solder bumps 1330 between interposer 1220 and substrate 1230. Similarly, the left-most and right-most of solder bumps 1330 beneath interposer 1225 are subjected to a higher level of shear strain than other ones of solder bumps 1330 between interposer 1225 and substrate 1230.

In general, shear strain (y) can be determined according to equation (1) below.

$$\gamma = \frac{\in_{thermal} l \Delta\theta}{h} \quad (1)$$

Within equation (1), $\in_{thermal}$ represents the thermal expansion coefficient, $l$ represents length, $\Delta\theta$ represents the difference in the angle $\theta$ before application of shear strain and after application of shear strain as shown in FIG. 13-2, and $h$ represents height. Referring to FIG. 13-2, for example, the angle $\theta$ is initially zero when solder bump 1330A is not exposed to shear strain. After solder bump 1330A is located between interposer 1225 and substrate 1230, thereby exposing solder bump 1330A to shear strain, solder bump 1330A flattens. In one example, as shown in FIG. 13-2, the vertex of $\theta$ is the center of the bottom flattened portion of solder bump 1330A. The angle $\theta$ is measured as shown from the center line aligned with the vertex to the end point of the top flattened portion of solder bump 1330A in contact with interposer 1225, e.g., approximately one half of the top flattened portion of solder bump 1330A in contact with interposer 1225.

Equation (1) can be applied to FIG. 13-1 to determine the shear strain to which solder bump 1330A, for example, is subjected. In that case, the variable $l$ represents a length measured from a center of an interposer, i.e., interposer 1225 in this case, to an outer edge solder bump 1330A. In this example, $l$ is one-half of $L_{int}$. The variable $h$ represents the height of solder bump 1330A. The coefficient of thermal expansion is, in effect, the difference between the coefficient of thermal expansion for substrate 1230 and the coefficient of thermal expansion for interposer 1225. For purposes of discussion, it can be assumed that the coefficient of thermal expansion for interposer 1225 is approximately 3 and the coefficient of thermal expansion for substrate 1230 is approximately 12. Accordingly, equation (1) can be reduced to equation (2) below.

$$\gamma = \frac{9 l \Delta\theta}{h} \quad (2)$$

As shown, the shear strain is generally dependent upon the length of each interposer, e.g., $L_{int}$. The shear strain to which solder bump 1330A is subjected can be reduced by reducing $L_{int}$, which also reduces $l$. Accordingly, rather than using a single, monolithic interposer, shear strain on solder bump 1330A and on other bumps similarly positioned, can be reduced by using two or more smaller interposers, e.g., interposers that have reduced length compared to a single, monolithic interposer.

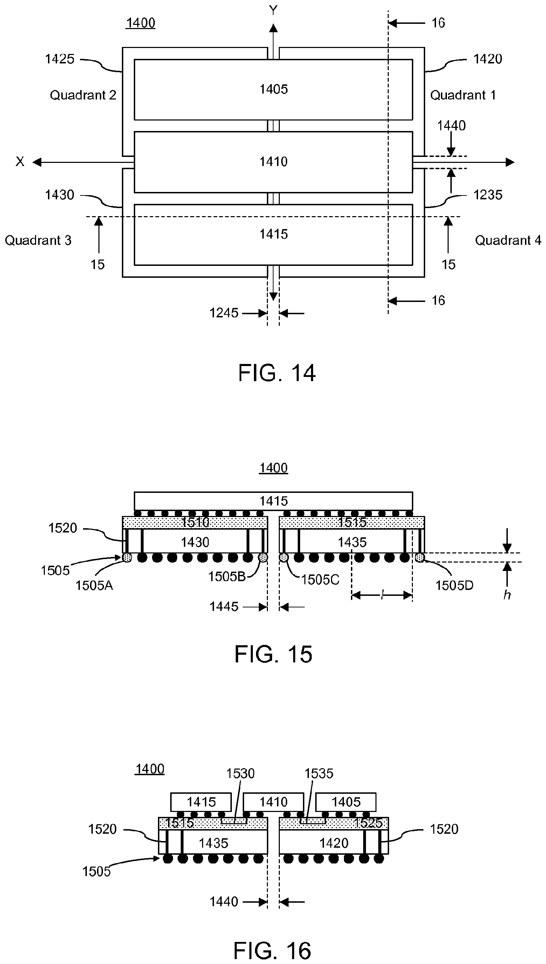

FIG. 14 is a block diagram illustrating a topographic view of an IC structure 1400, not forming part of the invention. IC structure 1400 is a multi-die IC structure. As pictured, IC structure 1400 can include a plurality of dies 1405, 1410, and 1415. Dies 1405-1415 can be coplanar and, as such can be mounted on interposers 1420, 1425, 1430, and 1435. Each of interposers 1420-1435 can be implemented as a silicon interposer substantially as described with reference to FIGs. 12 and 13. Interposers 1420-1435 can be coplanar and mounted on a substrate of an IC package within which IC structure 1400 can be implemented. For ease of illustration, the substrate is not shown in FIG. 14.

IC structure 1400 is shown superimposed over a Cartesian coordinate system in which the X-axis bisects IC 1400 into two equal halves and the Y-axis bisects IC structure 1400 into two equal halves. The X-axis is perpendicular to the Y-axis. As illustrated, interposer 1420 is located entirely within quadrant 1. Interposer 1425 is located entirely within quadrant 2. Interposer 1430 is located entirely within quadrant 3. Interposer 1435 is located entirely within quadrant 4.

For purposes of reference, the bottom surface of each interposer 1420-1435 can be referred to as the first surface. The top surface of each interposer 1420-1435 to which the dies are mounted can be referred to as the second surface. As shown, die 1405 is mounted on a portion of the second surface of interposer 1420 and a portion of the second surface of interposer 1425. Die 1405 is located within only quadrants 1 and 2. Die 1410 is mounted on a portion of the second surface of each of interposers 1420-1435 and is partly within each of quadrants 1-4. Die 1415 is mounted on a portion of the second surface of interposer 1430 and a portion of the second surface of interposer 1435. Thus, die 1415 is located only within quadrants 3 and 4.

Each of interposers 1420 and 1425 can include one or more inter-die wires that can be used to couple die 1405 with die 1410. Similarly, each of interposers 1430 and 1435 can include one or more inter-die wires that can be used to couple dies 1410-1415. Die 1410 can be configured with wires or signal paths that can couple interposer 1420 to one, or more or each of interposers 1425, 1430, and 1435. Similarly, die 1410 can be configured with wires or signals that can couple interposer 1425 with one, or more or each of interposers 1420, 1430, and 1435. Die 1405 can be configured with wires or signal paths that can couple interposer 1420 to interposer 1425. Similarly, die 1415 can be configured with wires or signal paths that can couple interposer 1430 with interposer 1435.

As discussed with reference to FIG. 13, each of interposers 1420-1435 can include one or more TSVs. Accordingly, die 1405 can be coupled to the substrate through one or more TSVs located within interposer 1420 and/or one or more TSVs located within interposer 1425. Die 1410 can be coupled to the substrate through one or more TSVs located within interposer 1420, interposer 1425, interposer 1430, and/or interposer 1435. Die 1415 can be coupled to the substrate through one or more TSVs located within interposer 1430 and/or one or more TSVs located within interposer 1435.

In general, interposer 1420 can be separated from interposer 1435 by a predetermined distance 1440. Similarly, interposer 1425 can be separated from interposer 1430 by the predetermined distance 1440. Accordingly, the separation described effectively forms a channel along the X-axis having a width of the distance 1440. Die 1410 effectively spans distance 1440 of the channel formed on the X-axis shown.

Interposer 1420 can be separated from interposer 1425 by a predetermined distance 1445. Similarly, interposer 1430 can be separated from interposer 1435 by the predetermined distance 1445. Accordingly, the separation described effectively forms a channel along the Y-axis having a width of the distance 1445. Each of dies 1405, 1410, and 1415 effectively spans distance 1445 of the channel formed on the Y-axis shown.

FIG. 15 is a block diagram illustrating a cross-sectional side view of IC structure 1400 of FIG. 14. More particularly, FIG. 15 illustrates a view of IC structure 1400 of FIG. 14 taken along cut-line 15-15. FIG. 15 illustrates the reduced length *l* that is achieved by using two or more interposers as opposed to a single, larger or monolithic interposer. Referring to FIG. 15, the particular ones of solder bumps 1505 that are subjected to increased levels of shear strain are illustrated with shading as opposed to the solid coloration of other ones of solder bumps 1505. In this example, four interposers are used, thereby reducing *l* and reducing the amount of shear strain placed on solder bumps 1505A-1505D.

Interposer 1430 can include an interconnect region 1510 that can be implemented as described with reference other interconnect regions already described within this specification. One or more inter-die wires formed within interconnect region 1510 can couple die 1410 and die 1415. Similarly, interposer 1435 can include an interconnect region 1515 that can be implemented as previously described. One or more inter-die wires formed within interconnect region 1515 can couple die 1410 to die 1415. FIG. 15 also illustrates that interposer 1430 and interposer 1435 each can include one or more TSVs 1520. TSVs 1520 allow dies to couple to a substrate through an interposer to connect to nodes external to IC structure 1400 and external to the IC package.

FIG. 16 is a block diagram illustrating a further cross-sectional side view of IC structure 1400 of FIG. 14. More particularly, FIG. 16 illustrates a view of IC structure 1400 of FIG. 14 taken along cut-line 16-16. As shown, interposer 1435 can include one or more inter-die wires such as inter-die wire 1530 coupling die 1415 with die 1410. Further, interposer 1420 can include an interconnect region 1525 that can be used to form one or more inter-die wires such as inter-die wire 1535. Inter-die wire 1535 can couple die 1410 with die 1405.

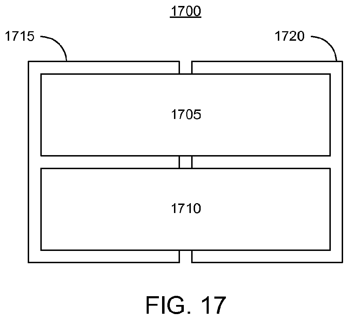

FIG. 17 is a block diagram illustrating a topographic view of an IC structure 1700, not forming part of the invention. IC structure 1700 is a multi-die IC structure. As pictured, IC structure 1700 can include a plurality of dies 1705 and 1710. Dies 1705-1710 can be coplanar and mounted on interposers 1715 and 1720. Interposers 1715 and 1720 each can be implemented as a silicon interposer substantially as described within this specification. Interposers 1715 and 1720 can be coplanar and mounted on a substrate of an IC package within which IC structure 1700 can be implemented. For ease of illustration, the substrate is not illustrated in FIG. 17.

A first (bottom) surface of interposer 1715 can be coupled to a top surface of the substrate, e.g., using solder bumps such as C4 type solder bumps. Similarly, a first (bottom) surface of interposer 1720 can be coupled to the top surface of the substrate also using solder bumps such as C4 type bumps. A second (top) surface of interposer 1715 can be coupled to a portion of a bottom surface of die 1705 and to a portion of a bottom surface of die 1710. A second (top) surface of interposer 1720 can be coupled to a portion of a bottom surface of die 1705 and to a portion of a bottom surface of die 1710. Dies 1705 and 1710 can be coupled to interposers 1715 and 1720 through solder bumps such as micro-bumps as previously described.

Each of interposers 1715 and 1720 can include one or more TSVs through which dies 1705 and 1710 can couple to the substrate. As such, die 1705 can couple to the substrate through both interposer 1715 and interposer 1720. Similarly, die 1710 can couple to the substrate through both interposer 1715 and interposer 1720. Each of interposers 1715 and 1720 can include an interconnect region having one or more inter-die wires that support the exchange of signals between dies 1705 and 1710.

It should be understood from the above description of several exemplary stacked die assemblies, multiple dies may be interconnected to one another over a larger interposer area than previously available by using multiple interposers. Even though the example of adding memory, such as DRAM, to an SSIT-based FPGA die stack was used, it should be understood that the following description applies to any stacked die assembly in which die-to-die interconnects are enhanced by use of multiple interposers within a same package. A stacked die assembly as described herein may not be as constrained by current lithography, margining for packaging and assembly, and/or availability of die-to-die interconnects. Furthermore, even though the above description is generally in terms of passive interposers, it should be understood that either or both of the interposers in the multiple-interposer examples described herein may be active interposers, namely interposers with active components.

While the foregoing describes exemplary assemblies and methods, other and further embodiments in accordance with the one or more aspects may be devised without departing from the scope thereof, which is determined by the claims that follow. Claims listing steps do not imply any order of the steps. Trademarks are the property of their respective owners.

**Claims**

1. A stacked die assembly for integrated circuit dies of an integrated circuit device, comprising:

a first interposer (500A) formed on a wafer, the first interposer having a first offset region (515) which is a part of an interconnect restricted area (710), the first offset region (515) having a first boundary that is coterminous with a first edge of the first interposer;
a second interposer (500B) formed on the wafer and severed from the first interposer (500A), the second interposer having a second offset region (516) which is a part of the interconnect restricted area, the second offset region (516) having a second boundary that is coterminous with a second edge of the second interposer, wherein the first edge of the first interposer and the second edge of the second interposer are positioned substantially side by side for abutting one another and the interconnect restricted area has interconnects but does not have fine pitch interconnects;
a first integrated circuit die (300) mounted on and interconnected to the first interposer and the second interposer via fine pitch interconnects (715, 1315);
a second integrated circuit die (303) mounted on and interconnected to the second interposer via fine pitch interconnects (715, 1315); and
the fine pitch interconnects being located outside the interconnect restricted area of the first interposer and the second interposer;
wherein signals are routed between the first interposer and the second interposer via the first integrated circuit die and the fine pitch interconnects, and signals are routed between the first integrated circuit die and the second integrated circuit die via a plurality of conductive lines of the second interposer which are outside of the second offset region; and
some of fine pitch interconnects (715, 1315) are coupled to connectors (711, 1330) on an opposite side of the first and second interposers (500A, 500B) via through-substrate vias (712, 1335), some of the through substrate vias (712, 1335) extending through the first interposer (500A) and some of the through substrate vias (712, 1335) extending through the second interposer (500B), wherein the connectors (711, 1330) are larger than the fine pitch interconnects (715, 1315) and the interconnect density of the fine pitch interconnects (715, 1315) is greater that that of the connectors (711, 1330).

2. The stacked die assembly of claim 1, wherein:

the signals routed between the first interposer and the second interposer avoid the interconnect restricted area of the first interposer and the second interposer.

3. The stacked die assembly according to claim 1 or claim 2, further comprising a third integrated circuit die (303-N) coupled to the first interposer, wherein the first integrated circuit die provides a communication bridge between the second integrated circuit die and the third integrated circuit die.

4. The stacked die assembly according to claim 2 or claim 3, wherein:

the fine pitch interconnects includes a plurality of die-to-die interconnects;
a first portion of the plurality of die-to-die interconnects interconnect the first integrated circuit die to the first interposer;
a second portion of the plurality of die-to-die interconnects interconnect the first integrated circuit die to the second interposer;
wherein the first portion and the second portion of the plurality of die-to-die interconnects are disposed on opposing sides of the interconnect restricted area;
a third portion of the plurality of die-to-die interconnects interconnect the second integrated circuit die to the second interposer;
a portion of the plurality of conductive lines of the second interposer are coupled to the second portion of the plurality of die-to-die interconnects and the third portion of the plurality of die-to-die interconnects in order to interconnect the first integrated circuit die to the second integrated circuit die; and
wherein the second portion of the plurality of die-to-die interconnects are located outside the interconnect restricted area, and the portion of the plurality of conductive lines are located outside of the second offset region of the second interposer associated with the interconnect restricted area.

5. The stacked die assembly according to any of claims 2-4, wherein the interconnect restricted area includes no metal layer and no via layer used for providing a fine pitch interconnect.

6. The stacked die assembly according to claim 1, wherein:
a first height of the first interposer is the same as a second height of the second interposer.

7.  The stacked die assembly according to any of claims 1-6, wherein:

    the second integrated circuit die includes a vertical stack (720) of memory dies; and
    the second integrated circuit die includes interface logic (731) for the vertical stack of memory dies.

8.  A method for forming a stacked die assembly for integrated circuit dies of an integrated circuit device, comprising:

    interconnecting a first integrated circuit die (300), mounted on a first interposer (500A) formed on a wafer and a second interposer (500B) formed on the wafer and severed from the first interposer (500A), to the first interposer and the second interposer using fine pitch interconnects (715, 1315) located outside an interconnect restricted area (710) of the first interposer and the second interposer having interconnects but not having fine pitch interconnects, the first interposer has a first offset region (515) associated with the interconnect restricted area, the first offset region (515) having a first boundary that is coterminous with a first edge of the first interposer, and the second interposer has a second offset region (516) associated with the interconnect restricted area, the second offset region (516) having a second boundary that is coterminous with a second edge of the second interposer, and the first edge of the first interposer and the second edge of the second interposer are positioned substantially side by side for abutting one another;
    interconnecting a second integrated circuit die (303), mounted on the second interposer, to the second interposer using the fine pitch interconnects (715, 1315);
    routing signals between the first interposer and the second interposer via the first integrated circuit die and the fine pitch interconnects (715, 1315); and
    routing signals between the first integrated circuit die and the second integrated circuit die via conductive lines (715) of the second interposer which are outside of the second offset region; wherein
    some of fine pitch interconnects (715, 1315) are coupled to connectors (711, 1330) on an opposite side of the first and second interposers (500A, 500B) via through-substrate vias (712, 1335) , some of the through substrate vias (712, 1335) extending through the first interposer (500A) and some of the through substrate vias (712, 1335) extending through the second interposer (500B), and the connectors (711, 1330) are larger than the fine pitch interconnects (715, 1315) and the interconnect density of the fine pitch interconnects (715, 1315) is greater that that of the connectors (711, 1330).

9.  The method according to claim 8, further comprising:

    reserving a portion of each of the first interposer and the second interposer to provide the interconnect restricted area; and
    routing the signals between the first interposer and the second interposer comprises avoiding the interconnect restricted area of the first interposer and the second interposer.

10. The method according to claim 8 or claim 9, further comprising:

    interconnecting a third integrated circuit die (303-N) to the first interposer,
    wherein the first integrated circuit die provides a communication bridge between the second integrated circuit die and the third integrated circuit die.

11. The method according to any of claims 8-10, further comprising:

    forming the first interposer using a first mask set; and
    forming the second interposer using a second mask set;
    wherein the first mask set is different from the second mask set responsive at least in part to the second integrated circuit die being for a different type of integrated circuit than the first integrated circuit die.

12. The method according to claim 11, wherein:
    a first height of the first interposer is the same as a second height of the second interposer.

## Patentansprüche

1.  Gestapelte Plättchenbaugruppe für integrierte Schaltungsplättchen einer integrierten Schaltungsvorrichtung, umfassend:

    einen erster Interposer (500A), der auf einem Wafer gebildet ist, wobei der erste Interposer eine erste Versatzregion (515) aufweist, die ein Teil eines Bereichs mit eingeschränkter Zwischenverbindung (710) ist, wobei die erste Versatzregion (515) eine erste Begrenzung aufweist, die an einer ersten Kante des ersten Interposers angrenzend ist;
    einen zweiten Interposer (500B), der auf dem Wafer gebildet und abgetrennt von dem ersten Interposer (500A) ist, wobei der zweite Interposer eine zweite Versatzregion (516) aufweist, die ein Teil des Bereichs mit eingeschränkter Zwischenverbindung ist, wobei die zweite Versatzregion (516) ein zweite Begrenzung aufweist, die an einer zweiten Kante des zweiten Interposers angrenzend ist, wobei die erste Kante des ersten Interposers und die zweite Kante des zweiten Interposers im Wesentlichen Seite an Seite angeordnet sind, um aneinander zu stoßen, und der Bereich mit eingeschränkter Zwischenverbindung Zwischenverbindungen aufweist, aber keine fein beabstandeten Zwischenverbindungen aufweist;

ein erstes integriertes Schaltungsplättchen (300), montiert auf dem und verbunden mit dem ersten Interposer und dem zweiten Interposer über fein beabstandete Zwischenverbindungen (715, 1315);

ein zweites integriertes Schaltungsplättchen (303), montiert auf dem und verbunden mit dem zweiten Interposer über fein beabstandete Zwischenverbindungen (715, 1315); und

wobei die fein beabstandeten Zwischenverbindungen außerhalb des Bereichs mit eingeschränkter Zwischenverbindung des ersten Interposers und des zweiten Interposers angeordnet sind;

wobei Signale zwischen dem ersten Interposer und dem zweiten Interposer über das erste integrierte Schaltungsplättchen und die fein beabstandeten Zwischenverbindungen geleitet werden und Signale zwischen dem ersten integrierten Schaltungsplättchen und dem zweiten integrierten Schaltungsplättchen über eine Vielzahl von leitenden Leitungen des zweiten Interposers, die außerhalb der zweiten Versatzregion sind, geleitet werden; und

einige der fein beabstandeten Zwischenverbindungen (715, 1315) an Verbinder (711, 1330) an einer gegenüberliegenden Seite des ersten und zweiten Interposers (500A, 500B) über Durchkontaktierungen durch das Substrat (712, 1335) gekoppelt sind, einige der Durchkontaktierungen durch das Substrat (712, 1335) sich durch den ersten Interposer (500A) erstrecken und einige der Durchkontaktierungen durch das Substrat (712, 1335) sich durch den zweiten Interposer (500B) erstrecken, wobei die Verbinder (711, 1330) größer als die fein beabstandeten Zwischenverbindungen (715, 1315) sind und die Verschaltungsdichte der fein beabstandeten Zwischenverbindungen (715, 1315) größer als die der Verbinder (711, 1330) ist.

2. Gestapelte Plättchenbaugruppe nach Anspruch 1, wobei:

die Signale, die zwischen dem ersten Interposer und dem zweiten Interposer geleitet werden, den Bereich mit eingeschränkter Zwischenverbindung des ersten Interposers und des zweiten Interposers meiden.

3. Gestapelte Plättchenbaugruppe nach Anspruch 1 oder Anspruch 2, ferner umfassend ein drittes integriertes Schaltungsplättchen (303-N), das an den ersten Interposer gekoppelt ist,

wobei das erste integrierte Schaltungsplättchen eine Kommunikationsbrücke zwischen dem zweiten integrierten Schaltungsplättchen und dem dritten integrierten Schaltungsplättchen bereitstellt.

4. Gestapelte Plättchenbaugruppe nach Anspruch 2 oder Anspruch 3, wobei:

die fein beabstandeten Zwischenverbindungen eine Vielzahl von Plättchen-zu-Plättchen-Zwischenverbindungen enthalten;

ein erster Anteil der Vielzahl von Plättchen-zu-Plättchen-Zwischenverbindungen das erste integrierte Schaltungsplättchen mit dem ersten Interposer verbindet;

ein zweiter Anteil der Vielzahl von Plättchen-zu-Plättchen-Zwischenverbindungen das erste integrierte Schaltungsplättchen mit dem zweiten Interposer verbindet;

wobei der erste Anteil und der zweite Anteil der Vielzahl von Plättchen-zu-Plättchen-Zwischenverbindungen an gegenüberliegenden Seiten des Bereichs mit eingeschränkter Zwischenverbindung angeordnet sind;

ein dritter Anteil der Vielzahl von Plättchen-zu-Plättchen-Zwischenverbindungen das zweite integrierte Schaltungsplättchen mit dem zweiten Interposer verbindet;

ein Anteil der Vielzahl von leitenden Leitungen des zweiten Interposers an den zweiten Anteil der Vielzahl von Plättchen-zu-Plättchen-Zwischenverbindungen und den dritten Anteil der Vielzahl von Plättchen-zu-Plättchen-Zwischenverbindungen gekoppelt ist, um das erste integrierte Schaltungsplättchen mit dem zweiten integrierten Schaltungsplättchen zu verbinden; und

wobei der zweite Anteil der Vielzahl von Plättchen-zu-Plättchen-Zwischenverbindungen außerhalb des Bereichs mit eingeschränkter Zwischenverbindung angeordnet ist und der Anteil der Vielzahl von leitenden Leitungen außerhalb der zweiten Versatzregion des zweiten Interposers, die mit dem Bereich mit eingeschränkter Zwischenverbindung assoziiert ist, angeordnet ist.

5. Gestapelte Plättchenbaugruppe nach einem der Ansprüche 2-4, wobei der Bereich mit eingeschränkter Zwischenverbindung keine Metallschicht und keine Durchkontaktierungsschicht, die zum Bereitstellen einer fein beabstandeten Zwischenverbindung verwendet werden, enthält.

6. Gestapelte Plättchenbaugruppe nach Anspruch 1, wobei:

    eine erste Höhe des ersten Interposers gleich einer zweiten Höhe des zweiten Interposers ist.

7. Gestapelte Plättchenbaugruppe nach einem der Ansprüche 1-6, wobei:

    das zweite integrierte Schaltungsplättchen einen senkrechten Stapel (720) von Speicherplättchen enthält; und
    das zweite integrierte Schaltungsplättchen Schnittstellenlogik (731) für den senkrechten Stapel von Speicherplättchen enthält.

8. Verfahren zum Bilden einer gestapelten Plättchenbaugruppe für integrierte Schaltungsplättchen einer integrierten Schaltungsvorrichtung, umfassend:

    Verbinden eines ersten integrierten Schaltungsplättchens (300), das auf einem ersten Interposer (500A), der auf einem Wafer gebildet ist, und einem zweiten Interposer (500B), der auf dem Wafer gebildet und von dem ersten Interposer (500A) abgetrennt ist, montiert ist, mit dem ersten Interposer und dem zweiten Interposer unter Verwendung fein beabstandeter Zwischenverbindungen (715, 1315), die außerhalb eines Bereichs mit eingeschränkter Zwischenverbindung (710) des ersten Interposers und des zweiten Interposer angeordnet sind, die Zwischenverbindungen aufweisen, aber keine fein beabstandeten Zwischenverbindungen aufweisen, wobei der erste Interposer eine erste Versatzregion (515) aufweist, die mit dem Bereich mit eingeschränkter Zwischenverbindung assoziiert ist, wobei die erste Versatzregion (515) eine erste Begrenzung aufweist, die an einer ersten Kante des ersten Interposers angrenzend ist, und der zweite Interposer eine zweite Versatzregion (516) aufweist, die mit dem Bereich mit eingeschränkter Zwischenverbindung assoziiert ist, die zweite Versatzregion (516) eine zweite Begrenzung aufweist, die an einer zweiten Kante des zweiten Interposers angrenzend ist, und die erste Kante des ersten Interposers und die zweite Kante des zweiten Interposers im Wesentlichen Seite an Seite angeordnet sind, um aneinander zu stoßen;
    Verbinden eines zweiten integrierten Schaltungsplättchens (303), das auf dem zweiten Interposer montiert ist, mit dem zweiten Interposer unter Verwendung der fein beabstandeten Zwischenverbindungen (715, 1315);
    Leiten von Signalen zwischen dem ersten Interposer und dem zweiten Interposer über das erste integrierte Schaltungsplättchen und die fein beabstandeten Zwischenverbindungen (715, 1315); und
    Leiten von Signalen zwischen dem ersten integrierten Schaltungsplättchen und dem zweiten integrierten Schaltungsplättchen über leitende Leitungen (715) des zweiten Interposers, die außerhalb der zweiten Versatzregion sind; wobei einige der fein beabstandeten Zwischenverbindungen (715, 1315) an Verbinder (711, 1330) an einer gegenüberliegenden Seite des ersten und zweiten Interposers (500A, 500B) über Durchkontaktierungen durch das Substrat (712, 1335) gekoppelt sind, wobei einige der Durchkontaktierungen durch das Substrat (712, 1335) sich durch den ersten Interposer (500A) erstrecken und einige der Durchkontaktierungen durch das Substrat (712, 1335) sich durch den zweiten Interposer (500B) erstrecken und wobei die Verbinder (711, 1330) größer als die fein beabstandeten Zwischenverbindungen (715, 1315) sind und die Verschaltungsdichte der fein beabstandeten Zwischenverbindungen (715, 1315) größer als die der Verbinder (711, 1330) ist.

9. Verfahren nach Anspruch 8, ferner umfassend:

    Reservieren eines Anteils jedes des ersten Interposers und des zweiten Interposers, um den Bereich mit eingeschränkter Zwischenverbindung bereitzustellen; und
    wobei Leiten der Signale zwischen dem ersten Interposer und dem zweiten Interposer umfasst, den Bereich mit eingeschränkter Zwischenverbindung des ersten Interposers und des zweiten Interposers zu meiden.

10. Verfahren nach Anspruch 8 oder Anspruch 9, ferner umfassend:

    Verbinden eines dritten integrierten Schaltungsplättchens (303-N) mit dem ersten Interposer, wobei das erste integrierte Schaltungsplättchen eine Kommunikationsbrücke zwischen dem zweiten integrierten Schaltungsplättchen und dem dritten integrierten Schaltungsplättchen bereitstellt.

11. Verfahren nach einem der Ansprüche 8-10, ferner umfassend:

    Bilden des ersten Interposers unter Verwendung eines ersten Maskensatzes; und
    Bilden des zweiten Interposers unter Verwendung eines zweiten Maskensatzes;
wobei der erste Maskensatz von dem zweiten Maskensatz als Reaktion mindestens teilweise darauf, dass das zweite integrierte Schaltungsplättchen für einen anderen Typ von integrierter Schaltung als das erste integrierte Schaltungsplättchen vorgesehen ist, verschieden ist.

12. Verfahren nach Anspruch 11, wobei:
eine erste Höhe des ersten Interposers gleich einer zweiten Höhe des zweiten Interposers ist.

**Revendications**

1. Ensemble de puces empilées pour des puces de circuit intégré d'un dispositif à circuit intégré, comprenant :

un premier interposeur (500A) formé sur une tranche, le premier interposeur ayant une première région de décalage (515) qui fait partie d'une zone d'interconnexion restreinte (710), la première région de décalage (515) ayant une première limite qui coïncide avec un premier bord du premier interposeur ;
un second interposeur (500B) formé sur la tranche et séparé du premier interposeur (500A), le second interposeur ayant une seconde région de décalage (516) qui fait partie de la zone d'interconnexion restreinte, la seconde région de décalage (516) ayant une seconde limite qui coïncide avec un second bord du second interposeur, dans lequel le premier bord du premier interposeur et le second bord du second interposeur sont positionnés sensiblement côte à côte pour une mise en butée l'un contre l'autre et la zone d'interconnexion restreinte a des interconnexions, mais n'a pas d'interconnexions à pas fin ;
une première puce de circuit intégré (300) montée sur et interconnectée avec le premier interposeur et le second interposeur via des interconnexions à pas fin (715, 1315) ;
une deuxième puce de circuit intégré (303) montée sur et interconnectée avec le second interposeur via des interconnexions à pas fin (715, 1315) ; et
les interconnexions à pas fin étant situées à l'extérieur de la zone d'interconnexion restreinte du premier interposeur et du second interposeur ;
dans lequel des signaux sont acheminés entre le premier interposeur et le second interposeur via la première puce de circuit intégré et les interconnexions à pas fin, et des signaux sont acheminés entre la première puce de circuit intégré et la deuxième puce de circuit intégré via une pluralité de lignes conductrices du second interposeur qui sont à l'extérieur de la seconde région de décalage ; et
certaines des interconnexions à pas fin (715, 1315) sont couplées à des connecteurs (711, 1330) sur un côté opposé des premier et second interposeurs (500A, 500B) via des traversées de substrat (712, 1335), certaines des traversées de substrat (712, 1335) s'étendant à travers le premier interposeur (500A) et certaines des traversées de substrat (712, 1335) s'étendant à travers le second interposeur (500B), dans lequel les connecteurs (711, 1330) sont plus grands que les interconnexions à pas fin (715, 1315) et la densité d'interconnexions des interconnexions à pas fin (715, 1315) est supérieure à celle des connecteurs (711, 1330).

2. Ensemble de puces empilée selon la revendication 1, dans lequel :
les signaux acheminés entre le premier interposeur et le second interposeur évitent la zone d'interconnexion restreinte du premier interposeur et du second interposeur.

3. Ensemble de puces empilées selon la revendication 1 ou la revendication 2, comprenant en outre une troisième puce de circuit intégré (303-N) couplée au premier interposeur,
dans lequel la première puce de circuit intégré fournit un pont de communication entre la deuxième puce de circuit intégré et la troisième puce de circuit intégré.

4. Ensemble de puces empilées selon la revendication 2 ou la revendication 3, dans lequel :

les interconnexions à pas fin comprennent une pluralité d'interconnexions de puce à puce ;
une première partie de la pluralité d'interconnexions de puce à puce interconnecte la première puce de circuit intégré au premier interposeur ;
une deuxième partie de la pluralité d'interconnexions de puce à puce interconnecte la première puce de circuit intégré au second interposeur ;
dans lequel la première partie et la deuxième partie de la pluralité d'interconnexions de puce à puce sont disposées sur des côtés opposés de la zone d'interconnexion restreinte ;
une troisième partie de la pluralité d'interconnexions de puce à puce interconnecte la deuxième puce de circuit intégré au second interposeur ;
une partie de la pluralité de lignes conductrices du second interposeur est couplée à la deuxième partie de la pluralité d'interconnexions de puce à puce et à la troisième partie de la pluralité d'interconnexions de puce à puce pour interconnecter la première puce de circuit intégré à la deuxième puce de circuit intégré ; et

dans lequel la deuxième partie de la pluralité d'interconnexions de puce à puce est située à l'extérieur de la zone d'interconnexion restreinte, et la partie de la pluralité de lignes conductrices est située à l'extérieur de la seconde région de décalage du second interposeur associée à la zone d'interconnexion restreinte.

5. Ensemble de puces empilées selon l'une quelconque des revendications 2 à 4, dans lequel la zone d'interconnexion restreinte ne comprend aucune couche métallique et aucune couche de traversée utilisée pour fournir une interconnexion à pas fin.

6. Ensemble de puces empilées selon la revendication 1, dans lequel :

une première hauteur du premier interposeur est la même qu'une seconde hauteur du second interposeur.

7. Ensemble de puces empilée selon l'une quelconque des revendications 1 à 6, dans lequel :

la deuxième puce de circuit intégré comprend une pile verticale (720) de puces de mémoire ; et la deuxième puce de circuit intégré comprend une logique d'interface (731) pour l'empilement vertical de puces de mémoire.

8. Procédé de formation d'un ensemble de puces empilées pour des puces de circuit intégré d'un dispositif à circuit intégré, comprenant les étapes consistant à :

interconnecter une première puce de circuit intégré (300), montée sur un premier interposeur (500A) formé sur une tranche et un second interposeur (500B) formé sur la tranche et séparé du premier interposeur (500A), au premier interposeur et au second interposeur en utilisant des interconnexions à pas fin (715, 1315) situées à l'extérieur d'une zone d'interconnexion restreinte (710) du premier interposeur et du second interposeur ayant des interconnexions, mais n'ayant pas d'interconnexions à pas fin, le premier interposeur a une première région de décalage (515) associée à la zone d'interconnexion restreinte, la première région de décalage (515) ayant une première limite qui coïncide avec un premier bord du premier interposeur, et le second interposeur a une seconde région de décalage (516) associée à la zone d'interconnexion restreinte, la seconde région de décalage (516) ayant une seconde limite qui coïncide avec un second bord du second interposeur, et le premier bord du premier interposeur et le second bord du second interposeur sont positionnés sensiblement côte à côte pour une mise en butée l'un contre l'autre ;

interconnecter une deuxième puce de circuit intégré (303), montée sur le second interposeur, au second interposeur en utilisant les interconnexions à pas fin (715, 1315) ;

acheminer des signaux entre le premier interposeur et le second interposeur via la première puce de circuit intégré et les interconnexions à pas fin (715, 1315) ; et

acheminer des signaux entre la première puce de circuit intégré et la deuxième puce de circuit intégré via des lignes conductrices (715) du second interposeur qui sont à l'extérieur de la seconde région de décalage ; dans lequel

certaines des interconnexions à pas fin (715, 1315) sont couplées à des connecteurs (711, 1330) sur un côté opposé des premier et second interposeurs (500A, 500B) via des traversées de substrat (712, 1335), certaines des traversées de substrat (712, 1335) s'étendant à travers le premier interposeur (500A) et certaines des traversées de substrat (712, 1335) s'étendant à travers le second interposeur (500B), et les connecteurs (711, 1330) sont plus grands que les interconnexions à pas fin (715, 1315) et la densité d'interconnexions des interconnexions à pas fin (715, 1315) est supérieure à celle des connecteurs (711, 1330).

9. Procédé selon la revendication 8, comprenant en outre l'étape consistant à :

réserver une partie de chacun du premier interposeur et du second interposeur pour fournir la zone d'interconnexion restreinte ; et l'acheminement des signaux entre le premier interposeur et le second interposeur comprend l'étape consistant à éviter la zone d'interconnexion restreinte du premier interposeur et du second interposeur.

10. Procédé selon la revendication 8 ou la revendication 9, comprenant en outre l'étape consistant à :

interconnecter une troisième puce de circuit intégré (303-N) au premier interposeur, dans lequel la première puce de circuit intégré fournit un pont de communication entre la deuxième puce de circuit intégré et la troisième puce de circuit intégré.

11. Procédé selon l'une quelconque des revendications 8 à 10, comprenant en outre les étapes consistant à :

former le premier interposeur en utilisant un premier ensemble de masque ; et

former le second interposeur en utilisant un second ensemble de masque ;

dans lequel le premier ensemble de masque est différent du second ensemble de masque en réponse au moins en partie à la deuxième puce de circuit intégré étant destinée à un type de circuit intégré différent de la première puce de circuit intégré.

12. Procédé selon la revendication 11, dans lequel : une première hauteur du premier interposeur est la même qu'une seconde hauteur du second interposeur.

FIG. 1

EP 2 812 919 B1

FIG. 2

EP 2 812 919 B1

**FIG. 3**

**FIG. 4**

Max.
Interposer
Width
502

504

503

Max.
Interposer
Height
501

Max. Usable Interposer Area
510

500

FIG. 5

27

600A

W1 ≤ 502

W2 ≤ 502

Line-Side XCVRs
301

Sys.-Side
XCVRs
302A

Memory
Pool
303A

Line-System Bridge
(FPGA Fabric)
304

300

Memory
Pool
303B

Sys.-Side XCVRs
302B

Sys.-Side
XCVRs
302C

500A

515

516

500B

602

FIG. 6-1

FIG. 6-2

600C

| W1 ≤ 502 | | W2 ≤ 502 |

Line-Side XCVRs
301A

Sys.-Side XCVRs
302A

Memory Pool
303A

300A

Line-System Bridge
304A

Line-System Bridge
304B

Memory Pool
303B

300B

Line-Side XCVRs
301B

Sys.-Side XCVRs
302B

500A

515

516

500B

FIG. 6-3

SoC
300

Memory Pool
303

600

713
703
500A
712
701
702
710
715
711
704
500B

## FIG. 7-1

700

Memory Pool
303-N

720

SoC
300

Memory Pool
303-1

500A
515
516
500B

## FIG. 7-2

700

Memory Pool
303-N

•
•
•

730

Memory Pool
303-1

SoC
300

Memory Interface
731

500A

500B

FIG. 7-3

FIG. 8

EP 2 812 919 B1

EP 2 812 919 B1

FIG. 9-1

34

FIG. 9-2

1000

SoC
300

Memory Pool
303

703

704

500A

500B

701

702

1010

FIG. 10-1

1100

SoC
300C

Bridge
1110

Memory Pool
303

713

500A

500B

515

516

715

715

715

1010

FIG. 10-2

FIG. 11

<u>1200</u>

FIG. 12

<u>1200</u>

FIG. 13-1

FIG. 13-2

**FIG. 14**

**FIG. 15**

**FIG. 16**

FIG. 17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009244874 A1